# EUROPEAN PATENT APPLICATION

(11) **EP 4 723 829 A1**
(43) Date of publication of application: **08.04.2026**
(21) Application number: 25183402.4
(22) Date of filing: 17.06.2025
(51) Int. Cl.: H10D 30/01, H10D 30/47, H10D 30/83, H10D 62/10, H10D 62/17, H10D 64/23, H10D 84/01, H10D 84/08, H10D 84/82, H10D 88/00, H10D 62/832, H10D 62/85

(54) **SEMICONDUCTOR DEVICE**

(30) Priority: 02.10.2024 KR 20240134066; 14.10.2024 KR 20240139734
(71) Applicant: Samsung Electronics Co., Ltd., Suwon-si, Gyeonggi-do 16677 (KR)
(72) Inventor: PARK, Junhyuk, Suwon-si (KR); KIM, Jongseob, Suwon-si (KR); KIM, Myeongjin, Suwon-si (KR); KIM, Boram, Suwon-si (KR); HWANG, In Jun, Suwon-si (KR)
(74) Representative: Marks & Clerk LLP

(57) **Abstract**

A semiconductor device includes a semiconductor layer on a first surface of a substrate with a first conductivity type, a drain electrode on a second surface of the substrate, first and second well regions in the semiconductor layer, a conductivity type of each of the first and second well regions being a second conductivity type, a doping region between the first and second well regions, a conductivity type of the doping region being the first conductivity type, and a pair of high electron mobility transistors on the semiconductor layer. Each of the first and second well regions includes a first portion adjacent to the source electrode, and a second portion adjacent to the first surface. A maximum distance between the first portions of the first and second well regions is longer than a maximum distance between the second portions of the first and second well regions.

## Description

### BACKGROUND OF THE INVENTION

### (a) Field of the Invention

The present disclosure relates to a semiconductor device.

### (b) Description of the Related Art

In the modern society, semiconductor devices are closely related to our daily lives. In particular, power semiconductor devices which are used in various fields such as the transportation field, for example, electric vehicles, trains, and electric trams, renewable energy systems, for example, solar power generation and wind power generation, and mobile devices, are becoming increasingly important. Power semiconductor devices are semiconductor devices that are usable to handle high voltage or high current, and perform functions such as power conversion and control in large power systems and high-power electronic devices. Power semiconductor devices are designed for high-power applications, enabling them to manage large currents and endure high voltages with durability. For example, power semiconductor devices can handle voltages of hundreds to thousands of volts and currents of tens to thousands of amperes. Power semiconductor devices enhance electrical energy efficiency by reducing power losses. Further, power semiconductor devices can be stably driven in environments such as high temperatures.

These power semiconductor devices can be categorized by their materials, and for example, there are SiC power semiconductor devices and GaN power semiconductor devices. SiC or GaN may be used, instead of the conventional material of silicon (Si), to manufacture power semiconductor devices, allowing for improved stability at high temperatures and overcoming silicon's limitations. SiC power semiconductor devices offer high-temperature resistance and low power loss, making them ideal for applications such as electric vehicles and renewable energy systems. In contrast, GaN power semiconductor devices, though costly, excel in speed and efficiency, making them well-suited for fast charging of mobile devices and similar applications.

### SUMMARY OF THE INVENTION

The present disclosure relates to a semiconductor device which has an improved switching speed while withstanding high voltage.

According to an aspect of the present disclosure, a semiconductor device includes a substrate, a semiconductor layer positioned on a first surface of the substrate, wherein a conductivity type of the semiconductor layer is a first conductivity type, a drain electrode that is positioned on a second surface of the substrate which is opposite to the first surface, a first well region and a second well region positioned in the semiconductor layer and spaced apart from each other in a first direction parallel to an upper surface (e.g. the first surface) of the substrate, wherein a conductivity type of each of the first well region and the second well region is a second conductivity type different from the first conductivity type, a doping region positioned between the first well region and the second well region, wherein a conductivity type of the doping region is the first conductivity type, and a pair of high electron mobility transistors that are positioned on the semiconductor layer. Each of the pair of high electron mobility transistors includes a channel layer that is positioned on the semiconductor layer, a gate electrode that is positioned on the channel layer, and a source electrode and a connection electrode that are positioned on opposite sides of the gate electrode and are spaced apart in the first direction. The source electrode of each of the pair of high electron mobility transistors contacts each of the first well region and the second well region. The connection electrode of each of the pair of high electron mobility transistors contacts the doping region. Each of the first well region and the second well region includes a first portion adjacent to the source electrode, and a second portion adjacent to the first surface. When viewed in a plan view, a distance (e.g. maximum distance), in the first direction, between the first portion of the first well region and the first portion of the second well region is longer than a distance (e.g. maximum distance), in the first direction, between the second portion of the first well region and the second portion of the second well region.

According to an embodiment: each of the first well region and the second well region further includes a third portion that is positioned between the first portion and the second portion, and when viewed in a plan view, a distance (e.g. maximum distance) between the third portion of the first well region and the third portion of the second well region in the first direction is shorter than the distance (e.g. maximum distance) between the first portion of the first well region and the first portion of the second well region in the first direction, and is longer than the distance (e.g. maximum distance) between the second portion of the first well region and the second portion of the second well region in the first direction.

According to an aspect of the present disclosure, a semiconductor device includes a substrate, a semiconductor layer positioned on a first surface of the substrate, wherein a conductivity type of the semiconductor layer is a first conductivity type, a drain electrode that is positioned on a second surface of the substrate which is opposite to the first surface, a first well region and a second well region positioned in the semiconductor layer and spaced apart from each other in a first direction parallel to an upper surface of the substrate, wherein a conductivity type of each of the first well region and the second well region is a second conductivity type different from the first conductivity type, a doping region positioned between the first well region and the second well region, wherein a conductivity type of the doping region is the first conductivity type, and a pair of high electron mobility transistors that are positioned on the semiconductor layer. Each of the pair of high electron mobility transistors includes a channel layer that is positioned on the semiconductor layer, a barrier layer that is positioned on the channel layer, a gate electrode that is positioned on the barrier layer, and a source electrode and a connection electrode that are positioned on opposite sides of the gate electrode and are spaced apart in the first direction. The channel layer of each of the pair of high electron mobility transistors contains a material having electron mobility higher than electron mobility of the semiconductor layer. The source electrode of each of the pair of high electron mobility transistors contacts a corresponding well region of the first well region and the second well region. The connection electrode of each of the pair of high electron mobility transistors contacts the doping region. Each of the first well region and the second well region includes a first portion adjacent to the source electrode, and a second portion adjacent to the first surface. When viewed in a plan view, a distance (e.g. maximum distance), in the first direction, between the first portion of the first well region and the first portion of the second well region is longer than a distance (e.g. maximum distance), in the first direction, between the second portion of the first well region and the second portion of the second well region.

According to an aspect of the present disclosure, a semiconductor device includes a substrate, a semiconductor layer positioned on a first surface of the substrate, wherein a conductivity type of the semiconductor layer is a first conductivity type, a drain electrode that is positioned on a second surface of the substrate which is opposite to the first surface, a first well region and a second well region positioned in the semiconductor layer and spaced apart from each other in a first direction parallel to an upper surface of the substrate, wherein a conductivity type of each of the first well region and the second well region is a second conductivity type different from the first conductivity type, a doping region positioned between the first well region and the second well region, wherein a conductivity type of the doping region is the first conductivity type, and a pair of high electron mobility transistors that are positioned on the semiconductor layer. Each of the pair of high electron mobility transistors includes a channel layer that is positioned on the semiconductor layer, a barrier layer that is positioned on the channel layer, a gate electrode that is positioned on the barrier layer, and a source electrode and a connection electrode that are positioned on both sides of the gate electrode and are spaced apart in the first direction. The connection electrode is electrically connected to the drain electrode. The channel layer of each of the pair of high electron mobility transistors contains a material having electron mobility higher than electron mobility of the semiconductor layer. The source electrode of each of the pair of high electron mobility transistors contacts each of the first well region and the second well region. The connection electrode of each of the pair of high electron mobility transistors contacts the doping region. The semiconductor layer that is positioned between the first well region and the second well region includes a first semiconductor layer adjacent to the doping region, and a second semiconductor layer extending from the first semiconductor layer toward the first surface. A width, in the first direction, of the first semiconductor layer is larger than a width, in the first direction, of the second semiconductor layer.

According to an embodiment there is provided a semiconductor device comprising: a substrate; a semiconductor layer positioned on a first surface of the substrate, wherein a conductivity type of the semiconductor layer is a first conductivity type; a drain electrode that is positioned on a second surface of the substrate which is opposite to the first surface; a first well region and a second well region positioned in the semiconductor layer and spaced apart from each other in a first direction parallel to the first surface of the substrate, wherein a conductivity type of each of the first well region and the second well region is a second conductivity type different from the first conductivity type; a doping region positioned between the first well region and the second well region, wherein a conductivity type of the doping region is the first conductivity type; and a pair of transistors that are positioned on the semiconductor layer. Each of the pair of transistors includes: a channel layer that is positioned on the semiconductor layer; a gate electrode that is positioned on the channel layer; and a source electrode and a connection electrode that are positioned on opposite sides of the gate electrode and are spaced apart in the first direction. For each transistor, the source electrode of the transistor contact a respective one of the first well region and the second well region. The connection electrode of each of the pair of transistors contacts the doping region. Each of the first well region and the second well region includes a first portion adjacent to the source electrode of a corresponding one of the pair of transistors, and a second portion adjacent to the first surface. When viewed in a plan view, a distance (e.g. maximum distance), in the first direction, between the first portion of the first well region and the first portion of the second well region is longer than a distance (e.g. maximum distance), in the first direction, between the second portion of the first well region and the second portion of the second well region.

The transistors may each be a field effect transistor incorporating a channel formed at a junction between two materials (e.g. two semiconductor materials) with different band gaps. This form of transistor is otherwise known as a "high electron mobility transistor". For instance, each transistor may comprise a barrier layer and a channel layer formed one on the other. The barrier layer may contain a material having an energy band gap different from that of the channel layer. The barrier layer may be otherwise known as a channel supply layer. The barrier layer may induce a 2-dimensional electron gas in the channel layer to form a channel in the channel layer. According to the example embodiments, a semiconductor device can have an improved switching speed while withstanding high voltage.

At least some of the above and other features of the invention are set out in the claims.

### BRIEF DESCRIPTION OF THE DRAWINGS

FIG. 1 is a plan view illustrating a semiconductor device according to an example embodiment.
FIG. 2 is a cross-sectional view illustrating the semiconductor device according to the example embodiment.
FIG. 3 is an enlarged cross-sectional view of a region R1 of FIG. 2.
Each of FIGS. 4 to 6 is a cross-sectional view illustrating a semiconductor device according to an example embodiment.
Each of FIGS. 7 and 8 is a cross-sectional view illustrating a semiconductor device according to an example embodiment.
FIGS. 9 to 12 are cross-sectional views illustrating processes of manufacturing a semiconductor device according to an example embodiment in the order of the processes.
FIGS. 13 to 16 are cross-sectional views illustrating processes of manufacturing a semiconductor device according to an example embodiment in the order of the processes.
FIGS. 17 to 20 are cross-sectional views illustrating processes of manufacturing a semiconductor device according to an example embodiment in the order of the processes, and are views illustrating the processes which are performed after the process of forming the resultant structure of FIG. 12 or the process forming the resultant structure of FIG. 16.

### DETAILED DESCRIPTION OF THE EMBODIMENTS

In the following detailed description, only certain example embodiments have been shown and described, simply by way of illustration. The present invention can be variously implemented and is not limited to the following example embodiments.

The drawings and description are to be regarded as illustrative in nature and not restrictive. Like reference numerals designate like elements throughout the specification.

In addition, the size and thickness of each configuration shown in the drawings are arbitrarily shown for understanding and ease of description, but the present invention is not limited thereto. In the drawings, the thickness of layers, films, panels, regions, etc., are exaggerated for clarity. Further, in the drawings, for understanding and ease of description, the thickness of some layers and areas is exaggerated.

Further, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is "on" a reference portion, the element is located above or below the reference portion, and it does not necessarily mean that the element is located "above" or "on" in a direction opposite to gravity.

In addition, in the entire specification, unless explicitly described to the contrary, the word "comprise", and variations such as "comprises" or "comprising", will be understood to imply the inclusion of stated elements but not the exclusion of any other elements.

In this specification, "on a plane" refers to the view of a target part from above, while "on a cross-section" refers to the side view of a vertical cross-section of the target part. For instance, "on a plane" may refer to a view taken in a direction perpendicular to an upper surface of a substrate. For instance, "on a cross-section" may refer to a cross-sectional view taken along a view parallel to the upper surface of the substrate.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

When the terms "about" or "substantially" are used in this specification in connection with a numerical value, it is intended that the associated numerical value includes a manufacturing or operational tolerance (e.g., ±10%) around the stated numerical value. Nevertheless, any parameters listed as being "about" a particular numerical value may be considered equal to the particular numerical value (subject to manufacturing or operational tolerance). Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

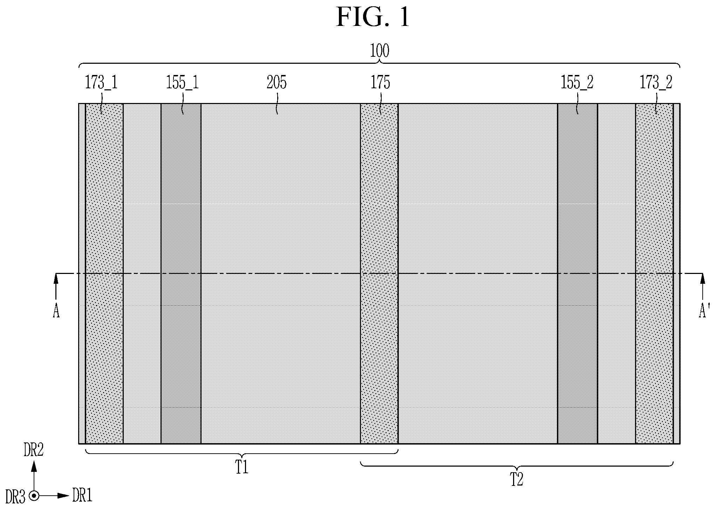

Hereinafter, a semiconductor device according to an example embodiment will be described with reference to FIGS. 1 to 3.

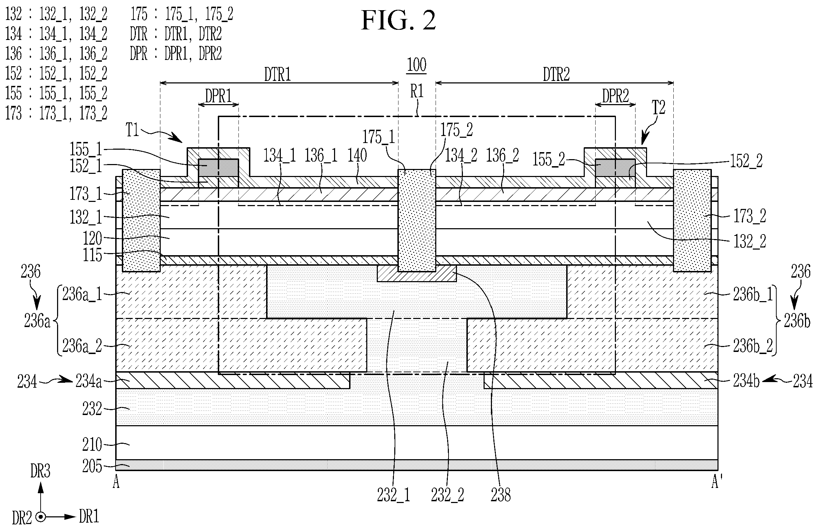

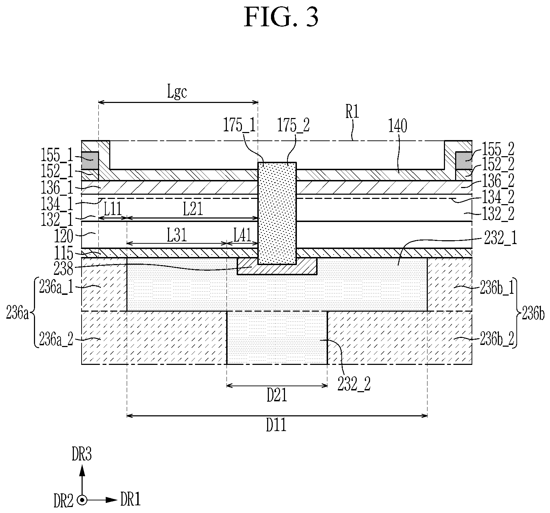

FIG. 1 is a plan view illustrating a semiconductor device according to an example embodiment. FIGS. 2 and 3 are cross-sectional views illustrating the semiconductor device according to the example embodiment. FIG. 1 shows a source electrode, a connection electrode, a drain electrode, and a gate electrode constituting the semiconductor device according to the example embodiment, and does not show the other constituent elements. FIG. 2 is a cross-sectional view taken along line A-A' of FIG. 1. FIG. 3 is an enlarged cross-sectional view of a region R1 of FIG. 2.

As shown in FIGS. 1 and 2, a semiconductor device 100 according to an example embodiment may include a substrate 210, a semiconductor layer 232 that is positioned on a first surface of the substrate 210, a drain electrode 205 that is positioned on a second surface of the substrate 210 which is the opposite surface to the first surface, a first well region 236a and a second well region 236b that are positioned inside the semiconductor layer 232, a doping region 238 that is positioned between the first well region 236a and the second well region 236b, and a pair of high electron mobility transistors T1 and T2 that are positioned on the semiconductor layer 232.

Each of the pair of high electron mobility transistors T1 and T2 may include a channel layer 132 that is positioned on the semiconductor layer 232, a barrier layer 136 that is positioned on the channel layer 132, a gate electrode 155 that is positioned on the barrier layer 136, and a source electrode 173 and a connection electrode 175. The source electrode 173 and the connection electrode 175 may be positioned on opposite sides of the gate electrode 155 and may be spaced apart from each other in a first direction DR1. The first direction DR1 may be a direction parallel with the first surface (otherwise known as an upper surface) of the substrate 210.

For example, the pair of high electron mobility transistors T1 and T2 may include a first transistor T1 and a second transistor T2. The first transistor T1 may include a first channel layer 132_1 that is positioned on the semiconductor layer 232, a first barrier layer 136_1 that is positioned on the first channel layer 132_1, a first gate electrode 155_1 that is positioned on the first barrier layer 136_1, and a first source electrode 173_1 and a first connection electrode 175_1 that are positioned on opposite sides of the first gate electrode 155_1 and are spaced apart from each other in the first direction DR1. The second transistor T2 may include a second channel layer 132_2 that is positioned on the semiconductor layer 232, a second barrier layer 136_2 that is positioned on the second channel layer 132_2, a second gate electrode 155_2 that is positioned on the second barrier layer 136_2, and a second source electrode 173_2 and a second connection electrode 175_2 that are positioned on opposite sides of the second gate electrode 155_2 and are spaced apart from each other in the first direction DR1.

The first channel layer 132_1 and the second channel layer 132_2 may be collectively referred to as a channel layer 132, and the following description of the channel layer 132 may be equally applied to each of the first channel layer 132_1 and the second channel layer 132_2. The first barrier layer 136_1 and the second barrier layer 136_2 may be collectively referred to as a barrier layer 136, and the following description of the barrier layer 136 may be equally applied to each of the first barrier layer 136_1 and the second barrier layer 136_2. The first gate electrode 155_1 and the second gate electrode 155_2 may be collectively referred to as a gate electrode 155, and the following description of the gate electrode 155 may be equally applied to each of the first gate electrode 155_1 and the second gate electrode 155_2. The first source electrode 173_1 and the second source electrode 173_2 may be collectively referred to as a source electrode 173, and the following description of the source electrode 173 may be equally applied to each of the first source electrode 173_1 and the second source electrode 173_2. The first connection electrode 175_1 and the second connection electrode 175_2 may be collectively referred to as a connection electrode 175, and the following description of the connection electrode 175 may be equally applied to each of the first connection electrode 175_1 and the second connection electrode 175_2.

In the example embodiment, the first connection electrode 175_1 and the second connection electrode 175_2 may be integrally formed. However, the present disclosure is not limited thereto, and the first connection electrode 175_1 and the second connection electrode 175_2 may be separate components. In this case, the first connection electrode 175_1 and the second connection electrode 175_2 may be connected by another constituent element.

The substrate 210 may be a semiconductor substrate containing SiC. For example, the substrate 210 may consist of a 4H SiC substrate. In some embodiments, the substrate 210 may consist of a 3C SiC substrate or a 6H SiC substrate. The substrate 210 may be doped with a first conductivity type impurity. For example, the first conductivity type impurity may be an n-type impurity. In other words, the substrate 210 may be doped with an n-type impurity. The substrate 210 may be doped with an n-type impurity at a high concentration (e.g. a higher concentration than the semiconductor layer 232). The resistivity of the substrate 210 may be in a range from about 0.005 Ωcm to about 0.035 Ωcm. The thickness of the substrate 210 may be in a range from about 100 µm to about 700 µm. The material, doping type, doping concentration, resistivity, thickness, and the like of the substrate 210 are not limited thereto, and may be variously changed. The substrate 210 may have the first surface and the second surface facing away from each other (e.g. opposite to each other). The first surface of the substrate 210 may be the upper surface of the substrate 210, and the second surface of the substrate 210 may be the lower surface of the substrate 210.

The drain electrode 205 may be positioned on the second surface, i.e., lower surface of the substrate 210. The upper surface of the drain electrode 205 may be in contact with the lower surface of the substrate 210. The drain electrode 205 may be in ohmic contact with the substrate 210. A region in the substrate 210 which is in contact with the drain electrode 205 may be doped with a relatively high concentration as compared to the other region. However, the present disclosure is not limited thereto, and another predetermined layer may be further positioned between the drain electrode 205 and the substrate 210. For example, a metal silicide layer may be positioned between the drain electrode 205 and the substrate 210. By the metal silicide layer, the drain electrode 205 and the substrate 210 may be electrically and smoothly connected. For example, the metal silicide layer may lower the contact resistance between the drain electrode 205 and the substrate 210.

The drain electrode 205 may contain a conductive material. For example, the drain electrode 205 may contain a metal, a metal alloy, a conductive metal nitride, a metal silicide, a doped semiconductor material, a conductive metal oxide, or a conductive metal oxynitride. The drain electrode 205 may be formed of the same material as that of the source electrode 173, or may be formed of a material different from that of the source electrode. The drain electrode 205 may consist of a single layer or multiple layers.

The semiconductor layer 232 may be positioned on the first surface of the substrate 210, i.e., the upper surface. The lower surface of the semiconductor layer 232 may be in contact with the upper surface of the substrate 210. However, the present disclosure is not limited thereto, and another predetermined layer may be further positioned between the substrate 210 and the semiconductor layer 232. The semiconductor layer 232 may be an epitaxy layer formed on the substrate 210 by epitaxial growth. The semiconductor layer 232 may contain SiC. For example, the semiconductor layer 232 may contain 4H SiC. The semiconductor layer 232 may be a first conductivity type. The semiconductor layer 232 may be doped with an impurity of the first conductivity type. For example, the first conductivity type impurity may be an n-type impurity. In other words, the semiconductor layer 232 may be doped with an n-type impurity. The semiconductor layer 232 may be doped with an n-type impurity at a low concentration. The doping concentration of the semiconductor layer 232 may be lower than the doping concentration of the substrate 210. In an embodiment, the semiconductor layer 232 and the substrate 210 may form an N- region and an N+ region, respectively, and at the interface, an N+/N- conductive junction is formed. The doping concentration of the semiconductor layer 232 may be in a range from about 1×10¹⁵ cm⁻³ to about 1×10¹⁷ cm⁻³. The thickness of the semiconductor layer 232 may be in a range from about 1 µm to about 13 µm. The material, doping type, doping concentration, thickness, and the like of the semiconductor layer 232 are not limited thereto, and may be variously changed.

The first well region 236a and the second well region 236b may be positioned inside the semiconductor layer 232. This does not mean that the first well region 236a and the second well region 236b are included in the semiconductor layer 232, and the first well region 236a and the second well region 236b may be regions which are distinguished from the semiconductor layer 232. The interface between the first well region 236a and the semiconductor layer 232 and the interface between the second well region 236b and the semiconductor layer 232 may be identified. The lower surfaces and side surfaces of the first well region 236a and the second well region 236b may be surrounded by the semiconductor layer 232. The first well region 236a and the second well region 236b may be embedded in the upper portion of the semiconductor layer 232. The first well region 236a and the second well region 236b may be formed in some regions of the semiconductor layer 232 by an ion implantation method. The first well region 236a and the second well region 236b may extend to a predetermined depth from the upper surface of the semiconductor layer 232. The upper surfaces of the first well region 236a and the second well region 236b may be positioned substantially at the same level as that of the upper surface of the semiconductor layer 232.

The first well region 236a and the second well region 236b may be in contact with the source electrode 173 (e.g. the respective source electrode 173). That is, the first well region 236a may be in contact with the first source electrode 173_1 and the second well region 236b may be in contact with the second source electrode 173_2. However, the present disclosure is not limited thereto, and another predetermined layer may be positioned between the source electrode 173 (e.g. the first source electrode 173_1 and the second source electrode 173_2), and each of the first well region 236a and the second well region 236b. In each of the spaces between the first well region 236a and the source electrode 173 (e.g. the first source electrode 173_1) and between the second well region 236b and the source electrode 173 (e.g. the second source electrode 173_2), a layer doped with an impurity of the same conductivity type as that of the first well region 236a and the second well region 236b at a high concentration may be included, and, for example, the layer which is doped at the high concentration may be doped at a concentration equal to or higher than about 1×10¹⁸ cm⁻³ and equal to or lower than about 5×10²⁰ cm⁻³. The upper surface of each of the first well region 236a and the second well region 236b may overlap the gate electrode 155 in a third direction DR3, and may not overlap the connection electrode 175 in the third direction DR3. The third direction DR3 may be a direction perpendicular to the upper surfaces of the first well region 236a and the second well region 236b. The third direction DR3 may be perpendicular to the first surface of the substrate 210. The third direction DR3 may define a height direction. For instance, a first element that is "higher than" a second element may be located further along the third direction DR3 (e.g. further from the first surface of the substrate 210) than the second element. Nevertheless, it will be appreciated that relative positions are defined relative to the structure of the device, and therefore need not imply any particular orientation of the device in use.

The first well region 236a and the second well region 236b may be spaced apart from each other in the first direction DR1. The first direction DR1 may be a direction parallel with the upper surfaces of the first well region 236a and the second well region 236b. Between the first well region 236a and the second well region 236b, the semiconductor layer 232 (e.g. a portion of the semiconductor layer 232) may be positioned. In the semiconductor layer 232 between the first well region 236a and the second well region 236b, a channel (i.e., an electrical conduction path) may be formed so as to extend in the third direction DR3 between the drain electrode 205 and the connection electrode 175. For example, the drain electrode 205 may be electrically connected to the connection electrode 175 via the channel and the substrate 210.

The first well region 236a and the second well region 236b may be formed in some regions of the semiconductor layer 232 by an ion implantation method. The first well region 236a and the second well region 236b may contain SiC. For example, the first well region 236a and the second well region 236b may contain 4H SiC. The first well region 236a and the second well region 236b may be doped with an impurity of a second conductivity type. The first well region 236a and the second well region 236b may be doped into a region having a conductivity type different from a conductivity type of the semiconductor layer 232. The conductivity type of a semiconductor refers to the nature of the charge carriers that dominate its electrical conduction. If the dominant charge carriers of a semiconductor layer are electrons, the conductivity type of the semiconductor layer corresponds to as an n-type. If the dominant charge carriers of a semiconductor layer are holes, the conductivity type of the semiconductor layer corresponds to a p-type. For example, the second conductivity type impurity may be a p-type impurity. In other words, the first well region and the second well region may be doped with a p-type impurity. The first well region 236a and the second well region 236b may be doped with a p-type impurity at a low concentration (e.g. a concentration lower than the doping concentration of the substrate 210). The doping concentration of the first well region 236a and the second well region 236b may be equal to or higher than about 1×10¹⁷ cm⁻³ and equal to or lower than about 1×10¹⁹ cm⁻³. The material, doping type, doping concentration, and the like of the first well region 236a and the second well region 236b are not limited thereto, and may be variously changed.

In the example embodiment, each of the first well region 236a and the second well region 236b may include a first portion 236a_1 or 236b_1 adjacent to the source electrode 173, and a second portion 236a_2 or 236b_2 adjacent to the first surface of the substrate 210, i.e., the upper surface of the substrate 210. The first portion 236a_1 of the first well region 236a may be adjacent to the first source electrode 173_1. The first portion 236b_1 of the second well region 236b may be adjacent to the second source electrode 173_2. The first portions 236a_1 and 236b_1 may correspond to the upper portions of the first well region 236a and the second well region 236b, and the second portions 236a_2 and 236b_2 may correspond to the lower portions of the first well region 236a and the second well region 236b. The first portions 236a_1 and 236b_1 may be positioned on the second portions 236a_2 and 236b_2. The doping concentrations of the first portions 236a_1 and 236b_1 and the second portions 236a_2 and 236b_2 may be the same or different from each other. For example, the first portions 236a_1 and 236b_1 may have a doping concentration higher than that of the second portions 236a_2 and 236b_2; however, the present disclosure is not limited thereto. The distance between the first portion 236a_1 of the first well region 236a and the first portion 236b_1 of the second well region 236b in the first direction DR1 may be greater than the distance between the second portion 236a_2 of the first well region 236a and the second portion 236b_2 of the second well region 236b in the first direction DR1. In an embodiment, the shortest distance, in the first direction DR1, between the first portion 236a_1 of the first well region 236a and the first portion 236b_1 of the second well region 236b may be greater than the shortest distance, in the first direction DR1, between the second portion 236a_2 of the first well region 236a and the second portion 236b_2 of the second well region 236b. In an embodiment, the maximum distance, in the first direction DR1, between the first portion 236a_1 of the first well region 236a and the first portion 236b_1 of the second well region 236b may be greater than the maximum distance, in the first direction DR1, between the second portion 236a_2 of the first well region 236a and the second portion 236b_2 of the second well region 236b. This will be further described below with reference to FIG. 3.

In the example embodiment, the semiconductor layer 232 (e.g. a portion of the semiconductor layer 232) may be positioned between the first well region 236a and the second well region 236b. The semiconductor layer 232 which is positioned between the first well region 236a and the second well region 236b may include a first semiconductor layer 232_1 that is positioned between the first portion 236a_1 and the first well region 236a and the first portion 236b_1 of the second well region 236b, and a second semiconductor layer 232_2 that is positioned between the second portion 236a_2 of the first well region 236a and the second portion 236b_2 of the second well region 236b. The first semiconductor layer 232_1 may be adjacent to the doping region 238. The second semiconductor layer 232_2 may extend from the first semiconductor layer 232_1 toward the upper surface of the substrate 210. The width of the first semiconductor layer 232_1 in the first direction DR1 may be larger than the width of the second semiconductor layer 232_2 in the first direction DR1. This will be further described below with reference to FIG. 3.

The lower surfaces of the first well region 236a and the second well region 236b may be in contact with the semiconductor layer 232. However, the present disclosure is not limited thereto, and another predetermined layer may be positioned between the semiconductor layer 232, and the first well region 236a and the second well region 236b. In the example embodiment, a doping layer 234 may be positioned between the lower surface of the first well region 236a and the semiconductor layer 232 and between the lower surface of the second well region 236b and the semiconductor layer 232. The doping layer 234 may include a first doping layer 234a that is positioned between the lower surface of the first well region 236a and the semiconductor layer 232, and a second doping layer 234b that is positioned between the lower surface of the second well region 236b and the semiconductor layer 232. The first doping layer 234a and the second doping layer 234b may be spaced apart from each other in the first direction DR1.

As shown in FIG. 2, the distance between the first doping layer 234a and the second doping layer 234b in the first direction DR1 may be longer than the distance between the second portion 236a_2 of the first well region 236a and the second portion 236b_2 of the second well region 236b in the first direction DR1. In an embodiment, the shortest distance (or the maximum distance), in the first direction DR1, between the first doping layer 234a and the second doping layer 234b may be greater than the shortest distance (or the maximum distance), in the first direction DR1, between the second portion 236a_2 of the first well region 236a and the second portion 236b_2 of the second well region 236b. However, the present disclosure is not limited thereto, and the distance or the shortest distance (or the maximum distance), in the first direction DR1, between the first doping layer 234a and the second doping layer 234b may be equal to or shorter than the distance or the shortest distance (or the maximum distance), in the first direction DR1, between the second portion 236a_2 of the first well region 236a and the second portion 236b_2 of the second well region 236b.

The doping layer 234 may be formed in some regions of the semiconductor layer 232 by an ion implantation method. The doping layer 234 may contain SiC. For example, the doping layer 234 may contain 4H SiC. The doping layer 234 may be doped with an n-type impurity. The doping concentration of the doping layer 234 may be higher than a doping concentration of the semiconductor layer 232. The doping concentration of the doping layer 234 may be equal to or higher than about 1×10¹⁷ cm⁻³ and equal to or lower than about 1×10¹⁹ cm⁻³. The doping layer 234 may cause carriers passing through the channel formed in the semiconductor layer 232 between the first well region 236a and the second well region 236b to spread in the horizontal direction along the lower surfaces of the first well region 236a and the second well region 236b, such that current flows through an area wider than that of the drain electrode 205.

The doping region 238 may be positioned between the first well region 236a and the second well region 236b. The doping region 238 may be positioned appropriately at the center between the first well region 236a and the second well region 236b. The doping region 238 may be positioned inside the semiconductor layer 232. The doping region 238 may be spaced apart from the first well region 236a and the second well region 236b by the semiconductor layer 232. The lower surface and side surface of the doping region 238 may be surrounded by the semiconductor layer 232. The doping region 238 may be embedded in the upper portion of the semiconductor layer 232 (e.g. in the upper portion of the first semiconductor layer 232_1). The doping region 238 may be formed in a partial region of the semiconductor layer 232 by an ion implantation method. The doping region 238 may extend to a predetermined depth from the upper surface of the semiconductor layer 232. The upper surface of the doping region 238 and the upper surface of the semiconductor layer 232 may be positioned substantially at the same level.

The doping region 238 may contain SiC. For example, the doping region 238 may contain 4H SiC. The doping region 238 may be doped with an impurity of the first conductivity type. The doping region 238 may be doped into the same type as that of the semiconductor layer 232. For example, the first conductivity type impurity may be an n-type impurity. In other words, the doping region 238 may be doped with an n-type impurity. The doping region 238 may be doped with an n-type impurity at a high concentration. The doping concentration of the doping region 238 may be equal to or higher than about 1×10¹⁸ cm⁻³ and equal to or lower than about 5×10²⁰ cm⁻³. The material, doping type, doping concentration, and the like of the doping region 238 are not limited thereto, and may be variously changed.

The doping region 238 may be in contact with the connection electrode 175. However, the present disclosure is not limited thereto, and another predetermined layer may be positioned between the doping region 238 and the connection electrode 175.

The channel layer 132 may be positioned on the semiconductor layer 232. The channel layer 132 may be a layer that forms a channel between the source electrode 173 and the connection electrode 175, and inside the channel layer 132, a 2-dimensional electron gas (2DEG) 134 may be positioned. The 2-dimensional electron gas 134 is a charge transfer model that is used in solid-state physics, and means a bunch of electrons that are tightly confined in two dimensions (for example, in directions on an x-y plane) such that they are free to migrate in the two dimensions but cannot migrate in the other dimension (for example, in a z direction). In other words, the 2-dimensional electron gas 134 may exist in a form like a two-dimensional sheet in a three-dimensional space. Such 2-dimensional electron gases mainly appear in semiconductor heterojunction structures, and in each of the pair of high electron mobility transistors T1 and T2 according to the example embodiment, the 2-dimensional electron gas 134 may occur at the interface between the channel layer 132 and the barrier layer 136. For example, the 2-dimensional electron gas 134 may occur at a portion inside the channel layer 132 adjacent to the barrier layer 136. The channel layer 132 may contain III-V materials, for example, one or more materials selected from nitrides containing Al, Ga, In, B, or a combination thereof. The channel layer 132 may consist of a single layer or multiple layers. The channel layer 132 may be formed of AlₓIn_{y}Ga_{1-x-y}N (wherein 0≤x≤1, 0≤y≤1, and x+y≤1). For example, the channel layer 132 may contain AlN, GaN, InN, InGaN, AlGaN, AlInN, AlInGaN, or a combination thereof. The channel layer 132 may be a layer doped with impurities, or may be a layer undoped (e.g. not doped) with impurities. The thickness of the channel layer 132 may be about hundreds of nm or less.

Between the semiconductor layer 232 and the channel layer 132, a seed layer 115 and a buffer layer 120 may be positioned. The seed layer 115 and the buffer layer 120 may be positioned between the first well region 236a and the channel layer 132 and between the second well region 236b and the channel layer 132. The seed layer 115 and the buffer layer 120 are layers that help to form the channel layer 132, and may be omitted in some cases. For example, when a substrate made of GaN is used as the channel layer 132, at least one of the seed layer 115 and the buffer layer 120 may be omitted. In consideration of the relatively high prices of substrates made of GaN, the semiconductor layer 232 made of SiC may be used as a substrate to grow a channel layer 132 containing GaN. In this case, since the lattice structure of SiC and the lattice structure of GaN are different, it may not be easy to grow the channel layer 132 directly on the semiconductor layer 232. Therefore, a seed layer 115 and a buffer layer 120 may be first grown on the semiconductor layer 232, and then the channel layer 132 may be grown on the buffer layer 120.

The seed layer 115 may be positioned directly on the semiconductor layer 232. However, the present disclosure is not limited thereto, and another predetermined layer may be further positioned between the semiconductor layer 232 and the seed layer 115. The seed layer 115 is a layer to serve as a seed for growing the buffer layer 120, and may consist of a crystal lattice structure to be a seed for the buffer layer 120. The buffer layer 120 may be positioned directly on the seed layer 115. However, the present disclosure is not limited thereto, and another predetermined layer may be further positioned between the seed layer 115 and the buffer layer 120. The seed layer 115 may contain III-V materials, for example, one or more materials selected from nitrides containing Al, Ga, In, B, or a combination thereof. The seed layer 115 may be formed of AlₓIn_{y}Ga_{1-x-y}N (wherein 0≤x≤1, 0≤y≤1, and x+y≤1). For example, the seed layer 115 may contain AlN, GaN, InN, InGaN, AlGaN, AlInN, AlInGaN, or a combination thereof.

The buffer layer 120 may be positioned on the seed layer 115. The buffer layer 120 may be positioned between the seed layer 115 and the channel layer 132. The buffer layer 120 may be a layer for mitigating differences in lattice constant and thermal expansion coefficient between the seed layer 115 and the channel layer 132 or preventing parasitic current (leakage current) from flowing through the channel layer 132. The buffer layer 120 may contain III-V materials, for example, one or more materials selected from nitrides containing Al, Ga, In, B, or a combination thereof. The buffer layer 120 may be formed of AlₓIn_{y}Ga_{1-x-y}N (wherein 0≤x≤1, 0≤y≤1, and x+y≤1). For example, the buffer layer 120 may contain AlN, GaN, InN, InGaN, AlGaN, AlInN, AlInGaN, or a combination thereof.

For example, the buffer layer 120 may include a superlattice layer that is positioned on the seed layer 115, and a high-resistivity layer that is positioned on the superlattice layer. The superlattice layer and the high-resistivity layer may be sequentially positioned on the seed layer 115. The superlattice layer may be positioned on the seed layer 115. The superlattice layer may be positioned directly on the seed layer 115. However, the present disclosure is not limited thereto, and between the seed layer 115 and the superlattice layer, other predetermined layers may be further positioned. The superlattice layer is a layer for migrating differences in lattice constant and thermal expansion coefficient between the semiconductor layer 232 and the channel layer 132, thereby relieving tensile stress and compressive stress that is generated between the semiconductor layer 232 and the channel layer 132 and relieving stress between all layers formed by growth in the final structure of each of the pair of high electron mobility transistors T1 and T2 according to the example embodiment. The superlattice layer may contain III-V materials, for example, one or more materials selected from nitrides containing Al, Ga, In, B, or a combination thereof. The superlattice layer may be formed of AlₓIn_{y}Ga_{1-x-y}N (wherein 0≤x≤1, 0≤y≤1, and x+y≤1). For example, the superlattice layer may contain AlN, GaN, InN, InGaN, AlGaN, AlInN, AlInGaN, or a combination thereof.

In the example embodiment, the superlattice layer may consist of multiple layers containing different materials and alternately stacked. For example, the superlattice layer may have a structure in which layers consisting of AlGaN and layers consisting of AlN are alternately stacked. In other words, AlGaN, AlN, AlGaN, AlN, AlGaN, and AlN are sequentially stacked to form the superlattice layer. The numbers of AlGaN layers and AlN layers which constitute the superlattice layer may be variously changed, and the materials which constitute the superlattice layer may be variously changed. As another example, the superlattice layer may have a structure in which layers consisting of AlGaN and layers consisting of GaN are alternately stacked. In other words, AlGaN, GaN, AlGaN, GaN, AlGaN, and GaN are sequentially stacked to form the superlattice layer. In the example embodiment, when the superlattice layer contains GaN, InN, AlGaN, AlInN, InGaN, AlN, AlInGaN, or a combination thereof, the superlattice layer may have an n-type semiconductor characteristic in which the concentration of electrons is greater than the concentration of holes; however, the present disclosure is not limited thereto.

The high-resistivity layer may be positioned on the superlattice layer. The high-resistivity layer may be positioned directly on the superlattice layer. However, the present disclosure is not limited thereto, and between the superlattice layer and the high-resistivity layer, other predetermined layers may be further positioned. The high-resistivity layer may be positioned between the superlattice layer and the channel layer 132. The high-resistivity layer is a layer for preventing leakage current from flowing through the channel layer 132, thereby preventing each of the pair of high electron mobility transistors T1 and T2 according to the example embodiment from being deteriorated. The high-resistivity layer may consist of a material having low conductivity such that the semiconductor layer 232 and the channel layer 132 can be electrically insulated from each other. The high-resistivity layer may have a resistivity value equal to or larger than 1.0×10⁶ Ω·cm. For example, the resistivity value of the high-resistivity layer may be equal to or larger than 1.0×10¹⁰ Ω·cm. As another example, the resistivity value of the high-resistivity layer may be equal to or larger than 1.0×10¹² Ω·cm. The resistivity value may be measured by forming a measurement electrode inside the high-resistivity layer such that current flows. The high-resistivity layer may contain III-V materials, for example, one or more materials selected from nitrides containing Al, Ga, In, B, or a combination thereof. The high-resistivity layer may be formed of AlₓIn_{y}Ga_{1-x-y}N (wherein 0≤x≤1, 0≤y≤1, and x+y≤1). For example, the high-resistivity layer may contain AlN, GaN, InN, InGaN, AlGaN, AlInN, AlInGaN, or a combination thereof. The high-resistivity layer may consist of a single layer or multiple layers.

The barrier layer 136 may be positioned on the channel layer 132. The barrier layer 136 may be positioned directly on the channel layer 132. However, the present disclosure is not limited thereto, and between the channel layer 132 and the barrier layer 136, other predetermined layers may be further positioned. A region of the channel layer 132 overlapping the barrier layer 136 between the source electrode 173 and the connection electrode 175 may become a drift region DTR. The drift region DTR may be positioned between the source electrode 173 and the connection electrode 175. The drift region DTR may refer to a region where carriers migrate when a potential difference occurs between the source electrode 173 and the connection electrode 175.

The pair of high electron mobility transistors T1 and T2 according to the example embodiment may be turned on and off according to whether voltage is applied to the gate electrode 155 and/or the magnitude of voltage which is applied to the gate electrode 155, thereby enabling or blocking carrier migration in the drift region DTR.

The barrier layer 136 may contain III-V materials, for example, one or more materials selected from nitrides containing Al, Ga, In, B, or a combination thereof. The barrier layer 136 may be formed of AlₓIn_{y}Ga_{1-x-y}N (wherein 0≤x≤1, 0≤y≤1, and x+y≤1). The barrier layer 136 may contain GaN, InN, AlGaN, AlInN, InGaN, AlN, AlInGaN, or a combination thereof. The energy band gap of the barrier layer 136 may be adjusted by the composition ratio of at least one of Al and In.

The barrier layer 136 may contain a semiconductor material having different characteristics from those of the channel layer 132. At least one of the polarization characteristics, energy band gap, and lattice constant of the barrier layer 136 may be different from that of the channel layer 132. For example, the barrier layer 136 may contain a material having an energy band gap different from that of the channel layer 132. In this case, the barrier layer 136 may have an energy band gap higher than that of the channel layer 132, and may have electrical polarizability higher than that of the channel layer 132. By this barrier layer 136, the 2-dimensional electron gas 134 may be induced in the channel layer 132 having relatively low electrical polarizability. In this regard, the barrier layer 136 may be referred to as a channel supply layer or a 2-dimensional electron gas supply layer. The 2-dimensional electron gas 134 may be formed in a portion of the channel layer 132 positioned below the interface between the channel layer 132 and the barrier layer 136. The 2-dimensional electron gas 134 may have very high electron mobility. For example, in GaN-based high electron mobility transistors (HEMTs), a 2-dimensional electron gas (2DEG) is typically formed at an interface between a barrier layer and a GaN-based channel layer. The electron mobility of the 2DEG at room temperature (approximately 300 K) is generally greater than 1,000 cm²/V·s, and in some implementations, may exceed 2,000 cm²/V·s or more. It is understood that the specific electron mobility may vary depending on the material composition of the barrier layer and the channel layer, the quality of the interface, and scattering mechanisms present in the device. However, an electron mobility greater than 1,000 cm²/V·s is generally regarded as indicative of "very high electron mobility" in GaN-based HEMT devices.

The barrier layer 136 may consist of a single layer or multiple layers. When the barrier layer 136 consists of multiple layers, the materials of the individual layers constituting the multiple layers may have different energy band gaps. In this case, the multiple layers constituting the barrier layer 136 may be disposed such that a layer closer to the channel layer 132 has a higher energy band gap.

The gate electrode 155 may be positioned on the barrier layer 136. The gate electrode 155 may overlap a partial region of the barrier layer 136. The gate electrode 155 may overlap a portion of the drift region DTR of the channel layer 132. The gate electrode 155 may be positioned between the source electrode 173 and the connection electrode 175. The gate electrode 155 may be spaced apart from the source electrode 173 and the connection electrode 175 in a first direction DR1. The first direction DR1 may be a direction parallel with the upper surface of the channel layer 132. The gate electrode 155 may be positioned approximately at the center between the source electrode 173 and the connection electrode 175. In other words, the separation distance between the gate electrode 155 and the source electrode 173 in the first direction DR1 may be similar to the separation distance between the gate electrode 155 and the connection electrode 175 in the first direction DR1. However, the position of the gate electrode 155 is not limited thereto, and may be variously changed. The gate electrode 155 may be positioned closer to the source electrode 173 than to the connection electrode 175. In other words, the separation distance between the gate electrode 155 and the source electrode 173 may be smaller than the separation distance between the gate electrode 155 and the connection electrode 175.

The gate electrode 155 may extend in a second direction DR2 different from the first direction DR1 on a plane. The second direction DR2 may be a direction parallel with the upper surface of the channel layer 132 and may be a direction intersecting the first direction DR1. For example, the second direction DR2 may be a direction perpendicular to the first direction DR1. The second direction DR2 may be a direction parallel to the first surface of the substrate 210. The gate electrode 155 may have a rod shape extending along the second direction DR2.

The gate electrode 155 may contain a conductive material. For example, the gate electrode 155 may contain a metal, a metal alloy, a conductive metal nitride, a metal silicide, a doped semiconductor material, a conductive metal oxide, or a conductive metal oxynitride. For example, the gate electrode 155 may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The gate electrode 155 may consist of a single layer or multiple layers.

In some example embodiments, the semiconductor device may further include a hard mask layer (not shown in the drawings) which is positioned on the gate electrode 155. The hard mask layer may be a hard mask used to perform patterning on a gate electrode material layer in the procedure of forming the gate electrode 155. However, the hard mask layer may be removed according to an etching condition during etching on the gate electrode material layer. As an example, the hard mask layer may contain a silicon oxide, a silicon nitride, a silicon oxynitride, or a combination thereof.

The pair of high electron mobility transistors T1 and T2 according to the example embodiment may further include a gate semiconductor layer 152 that is positioned between the barrier layer 136 and the gate electrode 155. The gate semiconductor layer 152 may be positioned on the barrier layer 136. On the gate semiconductor layer 152, the gate electrode 155 may be positioned. The gate electrode 155 may be in contact with the gate semiconductor layer 152. The lower surface of the gate electrode 155 may be in contact with the gate semiconductor layer 152. However, the present disclosure is not limited thereto, and between the gate electrode 155 and the gate semiconductor layer 152, other predetermined layers may be further positioned. The gate electrode 155 may be brought into Schottky contact with the gate semiconductor layer 152. However, the present disclosure is not limited thereto, and in some cases, the gate electrode 155 may be brought into ohmic contact with the gate semiconductor layer 152. The gate semiconductor layer 152 may overlap the gate electrode 155 in a third direction DR3. The third direction DR3 may be a direction perpendicular to the first direction DR1 and the second direction DR2. In other words, the third direction DR3 may be a direction perpendicular to the upper surface of the channel layer 132. The gate electrode 155 may be patterned using the same mask as that for the gate semiconductor layer 152.

Accordingly, the gate electrode 155 may have substantially the same plane shape as that of the gate semiconductor layer 152. The gate electrode 155 may have substantially the same width as that of the gate semiconductor layer 152.

The gate semiconductor layer 152 may be positioned between the source electrode 173 and the connection electrode 175. The gate semiconductor layer 152 may be spaced apart from the source electrode 173 and the connection electrode 175. The gate semiconductor layer 152 may be positioned approximately at the center between the source electrode 173 and the connection electrode 175. In other words, the separation distance between the gate semiconductor layer 152 and the source electrode 173 in the first direction DR1 may be similar to the separation distance between the gate semiconductor layer 152 and the connection electrode 175 in the first direction DR1. However, the position of the gate semiconductor layer 152 is not limited thereto, and may be variously changed. The gate semiconductor layer 152 may be positioned closer to the source electrode 173 than to the connection electrode 175. In other words, the separation distance between the gate semiconductor layer 152 and the source electrode 173 may be smaller than the separation distance between the gate semiconductor layer 152 and the connection electrode 175.

The gate semiconductor layer 152 may contain III-V materials, for example, one or more materials selected from nitrides containing at least one material of Al, Ga, In, and B. The gate semiconductor layer 152 may be formed of AlₓIn_{y}Ga_{1-x-y}N (wherein 0≤x≤1, 0≤y≤1, and x+y≤1). For example, the gate semiconductor layer 152 may contain at least one of AlN, GaN, InN, InGaN, AlGaN, AlInN, and AlInGaN. The gate semiconductor layer 152 may contain a material having an energy band gap different from that of the barrier layer 136. For example, the gate semiconductor layer 152 may contain GaN, and the barrier layer 136 may contain AlGaN. The gate semiconductor layer 152 may be doped with a predetermined impurity. In this case, the impurity with which the gate semiconductor layer 152 is doped may be a p-type impurity. The dominant charge carriers of the gate semiconductor layer 152 doped with a p-type impurity are holes. For example, the gate semiconductor layer 152 may contain GaN doped with a p-type impurity. In other words, the gate semiconductor layer 152 may consist of a p-GaN layer. However, the gate semiconductor layer 152 is not limited thereto, and may be a p-AlGaN layer. For example, the impurity with which the gate semiconductor layer 152 is doped may be magnesium (Mg). The gate semiconductor layer 152 may consist of a single layer or multiple layers.

By the gate semiconductor layer 152, a depletion region DPR may be formed inside the channel layer 132. The depletion region DPR may be positioned inside the drift region DTR, and may have a width smaller than that of the drift region DTR. As the gate semiconductor layer 152 having an energy band gap different from that of the barrier layer 136 is positioned on the barrier layer 136, the level of the energy band of a portion of the barrier layer 136 overlapping the gate semiconductor layer 152 may be raised. Accordingly, the depletion region DPR may be formed in the region of the channel layer 132 overlapping the gate semiconductor layer 152. The depletion region DPR may be a region on the channel path of the channel layer 132 where the 2-dimensional electron gas 134 is not formed or which has an electron concentration lower than that of the other regions. In other words, the depletion region DPR may refer to a region in the drift region DTR where the flow of the 2-dimensional electron gas 134 is cut off. As the depletion region DPR is generated, no current may flow between the source electrode 173 and the connection electrode 175, and the channel path may be blocked. Accordingly, each of the pair of high electron mobility transistors T1 and T2 according to the example embodiment may have a normally-off characteristic.

In other words, each of the pair of high electron mobility transistors T1 and T2 according to the example embodiment may be a normally-off high electron mobility transistor (HEMT). In a normal state in which voltage is not applied to the gate electrode 155, the depletion region DPR may exist, and each of the pair of high electron mobility transistors T1 and T2 according to the example embodiment may be off. When a voltage equal to or higher than a threshold voltage is applied to the gate electrode 155, the depletion region DPR may disappear, and the 2-dimensional electron gas 134 may continue inside the drift region DTR, without being cut. In other words, the 2-dimensional electron gas 134 may be formed over the entire channel path between the source electrode 173 and the connection electrode 175, and each of the pair of high electron mobility transistors T1 and T2 according to the example embodiment may be turned on. In summary, each of the pair of high electron mobility transistors T1 and T2 according to the example embodiment may include semiconductor layers having different electrical polarization characteristics, and a semiconductor layer having relatively high polarizability may cause the 2-dimensional electron gas 134 in another semiconductor layer forming a heterojunction with it. This 2-dimensional electron gas 134 may be used as a channel between the source electrode 173 and the connection electrode 175, and the continuation or interruption of the flow of the 2-dimensional electron gas 134 may be controlled by a bias voltage that is applied to the gate electrode 155. In the gate-off state, the flow of the 2-dimensional electron gas 134 may be blocked, whereby no current flows between the source electrode 173 and the connection electrode 175. In the gate-on state, as the flow of the 2-dimensional electron gas 134 continues, current may flow between the source electrode 173 and the connection electrode 175.

The seed layer 115, the buffer layer 120, the channel layer 132, the barrier layer 136, and the gate semiconductor layer 152 described above may be sequentially stacked on the semiconductor layer 232. In the pair of high electron mobility transistors T1 and T2 according to the example embodiment, at least one of the seed layer 115, the buffer layer 120, and the gate semiconductor layer 152 described above may be omitted. The seed layer 115, the buffer layer 120, the channel layer 132, the barrier layer 136, and the gate semiconductor layer 152 described above may consist of semiconductor materials based on the same material, and the material composition ratios of the individual layers may be different from one another in view of the roles of the individual layers, the performance required for the pair of high electron mobility transistors T1 and T2, and the like.

In the example embodiment, each of the seed layer 115, the buffer layer 120, the channel layer 132, the barrier layer 136, and the gate semiconductor layer 152 may contain a semiconductor material different from that of the semiconductor layer 232. The semiconductor layer 232 may contain a first semiconductor material, and each of the seed layer 115, the buffer layer 120, the channel layer 132, the barrier layer 136, and the gate semiconductor layer 152 may contain a second semiconductor material. The second semiconductor material may be a material having electron mobility higher than that of the first semiconductor material. For example, the first semiconductor material may be SiC, and the second semiconductor material may be GaN.

In general, in a GaN HEMT, the sum of the thicknesses of layers formed by growing GaN should be equal to or larger than about 6 µm such that it has a high breakdown voltage characteristic capable of withstanding up to about 1200 V. In the example embodiment the sum of the thicknesses of the seed layer 115, the buffer layer 120, the channel layer 132, the barrier layer 136, and the gate semiconductor layer 152 may be equal to or smaller than about 3 µm. Although the sum of the thicknesses of the seed layer 115, the buffer layer 120, the channel layer 132, the barrier layer 136, and the gate semiconductor layer 152 is equal to or smaller than about 3 µm, the semiconductor device 100 according to the example embodiment may have a high breakdown voltage characteristic due to the substrate 210 and the semiconductor layer 232 that are positioned between the channel layer 132 and the drain electrode 205 and the first well region 236a and the second well region 236b that are positioned inside the semiconductor layer 232.

The pair of high electron mobility transistors T1 and T2 according to the example embodiment may further include a first protective layer 140 that is positioned on the barrier layer 136, the gate semiconductor layer 152, and the gate electrode 155. The first protective layer 140 may cover the upper surface of the barrier layer 136, and may cover the side surface of the gate semiconductor layer 152, and may cover the upper surface and side surface of the gate electrode 155. The first protective layer 140 may be in contact with the barrier layer 136, the gate semiconductor layer 152, and the gate electrode 155. The barrier layer 136, the gate semiconductor layer 152, the gate electrode 155, and the like may be protected and be isolated from other constituent elements by the first protective layer 140

The first protective layer 140 may contain an insulating material. For example, the first protective layer 140 may contain an oxide such as SiO₂ or Al₂O₃. As another example, the first protective layer 140 may contain a nitride such as SiN, or an oxynitride such as SiON. The first protective layer 140 may consist of a single layer or multiple layers.

The source electrode 173 and the connection electrode 175 may be spaced apart from each other, and the gate electrode 155 and the gate semiconductor layer 152 may be positioned between the source electrode 173 and the connection electrode 175. The gate electrode 155 and the gate semiconductor layer 152 are spaced apart from the source electrode 173 and the connection electrode 175. The source electrode 173 may be electrically connected to the channel layer 132 on one side of the gate electrode 155. The connection electrode 175 may be electrically connected to the channel layer 132 on the other side of the gate electrode 155. The source electrode 173 and the connection electrode 175 may be positioned on the outside of the drift region DTR of the channel layer 132. The interface between the source electrode 173 and the channel layer 132 may be one edge of the drift region DTR. Similarly, the interface between the connection electrode 175 and the channel layer 132 may be the other edge of the drift region DTR.

Hereinafter, the first well region 236a and the second well region 236b may be collectively referred to as a well region 236.

In the example embodiment, the source electrode 173 may be in contact with the well region 236. The bottom surface of the source electrode 173 may be in contact with the upper surface of the well region 236. The portion of the well region 236 which is in contact with the source electrode 173 may be doped at a high concentration. As shown in FIG. 2, a portion of the well region 236 which is in contact with the source electrode 173 may be recessed; however, the present disclosure is not limited thereto. The well region 236 may not be recessed, and the source electrode 173 may be positioned on the upper surface of the well region 236.

In the example embodiment, the connection electrode 175 may be in contact with the doping region 238. The bottom surface of the connection electrode 175 may be in contact with the upper surface of the doping region 238. The doping region 238 which is in contact with the connection electrode 175 may be doped at a high concentration. As shown in FIG. 2, a portion of the doping region 238 which is in contact with the connection electrode 175 may be recessed; however, the present disclosure is not limited thereto. The doping region 238 may not be recessed, and the connection electrode 175 may be positioned on the upper surface of the doping region 238.

For example, a first trench may pass through the first protective layer 140, the barrier layer 136, the channel layer 132, the buffer layer 120, and the seed layer 115, and form a recess in the upper surface of the well region 236. A second trench may pass through the first protective layer 140, the barrier layer 136, the channel layer 132, the buffer layer 120, and the seed layer 115, and form a recess in the upper surface of the doping region 238. The first trench and the second trench may be positioned on opposite sides of the gate electrode 155 and may be spaced apart from each other. Inside the first trench, the source electrode 173 may be positioned, and inside the second trench, the connection electrode 175 may be positioned. The source electrode 173 and the connection electrode 175 may be formed so as to fill the trenches.

Inside the first trench, the source electrode 173 may be in contact with the well region 236, the seed layer 115, the buffer layer 120, the channel layer 132, the barrier layer 136, and the first protective layer 140. The well region 236 may constitute the bottom surface and side walls of the first trench, and the seed layer 115, the buffer layer 120, the channel layer 132, the barrier layer 136, and the first protective layer 140 may constitute the side walls of the first trench. Accordingly, the source electrode 173 may be in contact with the upper surface and side surface of the well region 236. Further, the source electrode 173 may be in contact with the side surfaces of the seed layer 115, the buffer layer 120, the channel layer 132, the barrier layer 136, and the first protective layer 140. In other words, the source electrode 173 may cover the side surfaces of the well region 236, the seed layer 115, the buffer layer 120, the channel layer 132, the barrier layer 136, and the first protective layer 140.

Inside the second trench, the connection electrode 175 may be in contact with the doping region 238, the seed layer 115, the buffer layer 120, the channel layer 132, the barrier layer 136, and the first protective layer 140. The doping region 238 may form the bottom surface and side walls of the second trench, and the seed layer 115, the buffer layer 120, the channel layer 132, the barrier layer 136, and the first protective layer 140 may form the side walls of the second trench. Accordingly, the connection electrode 175 may be in contact with the upper surface and side surface of the doping region 238. Further, the connection electrode 175 may be in contact with the side surfaces of the seed layer 115, the buffer layer 120, the channel layer 132, the barrier layer 136, and the first protective layer 140. In other words, the connection electrode 175 may cover the side surfaces of the doping region 238, the seed layer 115, the buffer layer 120, the channel layer 132, the barrier layer 136, and the first protective layer 140.

The upper surfaces of the source electrode 173 and the connection electrode 175 may include regions protruding from the upper surface of the first protective layer 140. In some cases, at least one of the source electrode 173 and the connection electrode 175 may cover at least a portion of the upper surface of the first protective layer 140.

The source electrode 173 and the connection electrode 175 may be spaced apart from each other in the first direction DR1. The source electrode 173 and the connection electrode 175 may extend in the second direction DR2 on a plane. The source electrode 173 and the connection electrode 175 may extend in a direction parallel with the gate electrode 155.

The source electrode 173 and the connection electrode 175 may contain a conductive material. For example, the source electrode 173 and the connection electrode 175 may contain a metal, a metal alloy, a conductive metal nitride, a metal silicide, a doped semiconductor material, a conductive metal oxide, or a conductive metal oxynitride. For example, the source electrode 173 and the connection electrode 175 may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The source electrode 173 and the connection electrode 175 may consist of a single layer or multiple layers. The source electrode 173 and the connection electrode 175 may be in ohmic contact with the channel layer 132. The regions in the channel layer 132 which are in contact with the source electrode 173 and the connection electrode 175 may be doped at a relatively higher concentration, as compared to the other region(s).

In FIG. 2, it is shown that the pair of high electron mobility transistors T1 and T2 according to the example embodiment include a pair of source electrode 173 and connection electrode 175; however, the numbers of source electrodes 173 and connection electrodes 175 are not limited thereto. For example, the source electrode 173 may include a plurality of source electrodes stacked sequentially in the third direction DR3 on the channel layer 132, and the connection electrode 175 may include a plurality of connection electrodes stacked sequentially in the third direction DR3 on the channel layer 132.

The first transistor T1 may include the first channel layer 132_1, the first barrier layer 136_1 that is positioned on the first channel layer 132_1, the first gate electrode 155_1 that is positioned on the first barrier layer 136_1, and the first source electrode 173_1 and the first connection electrode 175_1 that are positioned on opposite sides of the first gate electrode 155_1 on the first channel layer 132_1. The first transistor T1 may include a first gate semiconductor layer 152_1 that is positioned between the first barrier layer 136_1 and the first gate electrode 155_1.

The second transistor T2 may include the second channel layer 132_2, the second barrier layer 136_2 that is positioned on the second channel layer 132_2, the second gate electrode 155_2 that is positioned on the second barrier layer 136_2, and the second source electrode 173_2 and the second connection electrode 175_2 that are positioned on opposite sides of the second gate electrode 155_2 on the second channel layer 132_2. The second transistor T2 may include a second gate semiconductor layer 152_2 that is positioned between the second barrier layer 136_2 and the second gate electrode 155_2.

The first channel layer 132_1 and the second channel layer 132_2 may be formed together in the same process as that for the barrier layer 136, and may contain the same material. The first barrier layer 136_1 and the second barrier layer 136_2 may be formed together in the same process, and may contain the same material. The first gate electrode 155_1 and the second gate electrode 155_2 may be formed together in the same process, and may contain the same material. The first gate semiconductor layer 152_1 and the second gate semiconductor layer 152_2 may be formed together in the same process, and may contain the same material. The first source electrode 173_1, the second source electrode 173_2, the first connection electrode 175_1, and the second connection electrode 175_2 may be formed together in the same process, and may contain the same material.

The first channel layer 132_1 may include a first drift region DTR1 which overlaps the first barrier layer 136_1 between the first source electrode 173_1 and the first connection electrode 175_1. The first drift region DTR1 may include a first depletion region DPR1 which overlaps the first gate semiconductor layer 152_1. Inside the first channel layer 132_1, a 2-dimensional electron gas 134_1 of a first channel may be positioned. When the first transistor T1 is in the ON state, since the flow of the 2-dimensional electron gas 134_1 of the first channel continues inside the first drift region DTR1, current may flow between the first source electrode 173_1 and the first connection electrode 175_1. When the first transistor T1 is in the OFF state, since the flow of the 2-dimensional electron gas 134_1 of the first channel is interrupted inside the first depletion region DPR1, current may not flow between the first source electrode 173_1 and the first connection electrode 175_1.

The second channel layer 132_2 may include a second drift region DTR2 which overlaps the second barrier layer 136_2 between the second source electrode 173_2 and the second connection electrode 175_2. The second drift region DTR2 may include a second depletion region DPR2 which overlaps the second gate semiconductor layer 152_2. Inside the second channel layer 132_2, a 2-dimensional electron gas 134_2 of a second channel may be positioned. When the second transistor T2 is in the ON state, since the flow of the 2-dimensional electron gas 134_2 of the second channel continues inside the second drift region DTR2, current may flow between the second source electrode 173_2 and the second connection electrode 175_2. When the second transistor T2 is in the OFF state, since the flow of the 2-dimensional electron gas 134_2 of the second channel is interrupted inside the second depletion region DPR2, current may not flow between the second source electrode 173_2 and the second connection electrode 175_2.

In respect to the first drift region DTR1 and the second drift region DTR2, the above description of the drift region DTR may be equally applied, and in respect to the first depletion region DPR1 and the second depletion region DPR2, the above description of the depletion region DPR may be equally applied. In respect to the 2-dimensional electron gas 134_1 of the first channel and the 2-dimensional electron gas 134_2 of the second channel, the above description of the 2-dimensional electron gas 134 may be equally applied.

In the example embodiment, the first transistor T1 and the second transistor T2 may be connected in parallel with each other. To the first source electrode 173_1 and the second source electrode 173_2, the same voltage (for example, a first power voltage) may be applied simultaneously. To the first gate electrode 155_1 and the second gate electrode 155_2, the same voltage (for example, a gate voltage) may be applied simultaneously. To the first connection electrode 175_1 and the second connection electrode 175_2, the same voltage (for example, a second power voltage) may be applied simultaneously. The first connection electrode 175_1 and the second connection electrode 175_2 may be integrally formed, and, hereinafter, this may be referred to as the connection electrode 175.

For example, a third power voltage higher than the first power voltage and the second power voltage may be applied to the drain electrode 205. For example, the third power voltage may be equal to or lower than 1200 V. To the connection electrode 175, the second power voltage lower than the third power voltage and higher than the first power voltage may be applied. Between the drain electrode 205 and the connection electrode 175, since there is no gate for switching, current may always flow due to a voltage difference. To the first source electrode 173_1 and the second source electrode 173_2, the first power voltage may be applied. For example, the first power voltage may be 0 V. According to a gate voltage which is applied to the first gate electrode 155_1, current may flow between the first source electrode 173_1 and the connection electrode 175, and according to a gate voltage which is applied to the second gate electrode 155_2, current may flow between the second source electrode 173_2 and the connection electrode 175. When a gate voltage which is applied to the first gate electrode 155_1 and the second gate electrode 155_2 is equal to or higher than a threshold voltage, current may flow between the first source electrode 173_1 and the connection electrode 175 and between the second source electrode 173_2 and the connection electrode 175. When the gate voltage which is applied to the first gate electrode 155_1 and the second gate electrode 155_2 is lower than the threshold voltage, current may not flow between the first source electrode 173_1 and the connection electrode 175 and between the second source electrode 173_2 and the connection electrode 175. In other words, according to the gate voltage which is applied to the first gate electrode 155_1 and the second gate electrode 155_2, the first transistor T1 and the second transistor T2 may be driven together.

Hereinafter, the structures and shapes of the first well region 236a, the second well region 236b, and the semiconductor layer 232 which is positioned between the first well region 236a and the second well region 236b will be further described with reference to FIG. 3.

As shown in FIGS. 2 and 3, the first well region 236a may include the first portion 236a_1 adjacent to the first source electrode 173_1, and the second portion 236a_2 adjacent to the upper surface of the substrate 210. The second well region 236b may include the first portion 236b_1 adjacent to the second source electrode 173_2, and the second portion 236b_2 adjacent to the upper surface of the substrate 210. Hereinafter, a description will be made with a focus on the first well region 236a, and the first portion 236a_1 and second portion 236a_2 of the first well region 236a. In respect to the second well region 236b, and the first portion 236b_1 and second portion 236b_2 of the second well region 236b, the description of the first well region 236a, and the first portion 236a_1 and second portion 236a_2 of the first well region 236a may be equally or similarly applied.

In the example embodiment, one side surface of the first well region 236a may have a step shape. The side surface of the first well region 236a which is positioned between the first gate electrode 155_1 and the first connection electrode 175_1 may have a step shape that declines as it approaches the first connection electrode 175_1 from the first gate electrode 155_1 along the first direction DR1.

In the example embodiment, the first well region 236a may include the first portion 236a_1 and the second portion 236a_2, and the first portion 236a_1 may be positioned at a level higher than that of the second portion 236a_2 from the upper surface of the substrate 210.

In the example embodiment, each of the side surfaces of the first portion 236a_1 and the side surfaces of the second portion 236a_2 may extend in the third direction DR3 perpendicular to the upper surface of the substrate 210. On a cross section along the first direction DR1 and the third direction DR3, each of the side surfaces of the first portion 236a_1 and the second portion 236a_2 may be a straight line.

In the example embodiment, the side surface of the first portion 236a_1, which is positioned between the first gate electrode 155_1 and the first connection electrode 175_1, may be closer to the first connection electrode 175_1 than the side surface of the first gate electrode 155_1 in the first direction DR1. In other words, the distance L11 in the first direction DR1 between the side surface of the first gate electrode 155_1 facing the first connection electrode 175_1 and the side surface of the first portion 236a_1 which is positioned between the first gate electrode 155_1 and the first connection electrode 175_1 may be greater than 0. Throughout the specification, the relative positions of constituent elements of the semiconductor device 100 and their corresponding distances are described with reference to a cross-sectional view of the semiconductor device 100, but they remain applicable when viewed in a plan view of the semiconductor device 100. The distances (e.g. distances between components) may vary (e.g. depending on relative vertical position along the third direction DR3). When comparing distances between components, corresponding distances may be compared. The distances may represent the shortest distances in the specified direction when viewed in a plan view. In an embodiment, the distances may represent the maximum distances in the specified direction when viewed in a plan view. In an embodiment, the shortest distances and the maximum distances are the same (e.g. the distances may not vary along the third direction DR3). The distance L21 in the first direction DR1 between the side surface of the first portion 236a_1 which is positioned between the first gate electrode 155_1 and the first connection electrode 175_1 and the side surface of the first connection electrode 175_1 may be shorter than the distance Lgc in the first direction DR1 between the side surfaces of the first gate electrode 155_1 and the first connection electrode 175_1 facing each other. The distance Lgc represents the distance (e.g. the shortest distance or the maximum distance) in the first direction DR1 between the first gate electrode 155_1 and the first connection electrode 175_1 when viewed in a plan view. The distance Lgc may correspond to the sum of the distance L11 and the distance L21.

In the example embodiment, the side surface of the second portion 236a_2, which is positioned between the first gate electrode 155_1 and the first connection electrode 175_1, may be closer to the first connection electrode 175_1 than the side surface of the first portion 236a_1 which is positioned between the first gate electrode 155_1 and the first connection electrode 175_1 in the first direction DR1. That is, the second portion 236a_1 has a side surface that is positioned between the first connection electrode 175_1 and the side surface of the first portion 236a_1 that is positioned between the first gate electrode 155_1 and the first connection electrode 175_1. In other words, the distance L31 in the first direction DR1 between the side surface of the first portion 236a_1 which is positioned between the first gate electrode 155_1 and the first connection electrode 175_1 and the side surface of the second portion 236a_2 which is positioned between the first gate electrode 155_1 and the first connection electrode 175_1 may be greater than 0. The distance L41 in the first direction DR1 between the side surface of the second portion 236a_2 which is positioned between the first gate electrode 155_1 and the first connection electrode 175_1 and the side surface of the first connection electrode 175_1 may be shorter than the distance L21 in the first direction DR1 between the first connection electrode 175_1 and the side surface of the first portion 236a_1 which is positioned between the first gate electrode 155_1 and the first connection electrode 175_1. The sum of the distance L31 and the distance L41 may correspond to the distance L21.

In the example embodiment, the distance D11 in the first direction DR1 between the first portion 236a_1 of the first well region 236a and the first portion 236b_1 of the second well region 236b may be longer than the distance D21 in the first direction DR1 between the second portion 236a_2 of the first well region 236a and the second portion 236b_2 of the second well region 236b.

In the example embodiment, the semiconductor layer 232 may be positioned on the side surface of the first portion 236a_1 and the side surface and upper surface of the second portion 236a_2 which are positioned between the first gate electrode 155_1 and the first connection electrode 175_1. The semiconductor layer 232 may be positioned between the upper surface of the second portion 236a_2 and the channel layer 132_1, and may not be positioned between the upper surface of the first portion 236a_1 and the channel layer 132_1. In other words, a portion of the semiconductor layer 232 may be positioned in the third direction DR3 between the upper surface of the second portion 236a_2 and the lower surface of the channel layer 132_1.

In the example embodiment, the semiconductor layer 232 may include the first semiconductor layer 232_1 which is positioned between the first portion 236a_1 of the first well region 236a and the first portion 236b_1 of the second well region 236b, and the second semiconductor layer 232_2 which is positioned between the second portion 236a_2 of the first well region 236a and the second portion 236b_2 of the second well region 236b. The width D11 of the first semiconductor layer 232_1 in the first direction DR1 may be larger than the width D21 of the second semiconductor layer 232_2 in the first direction DR1. The width D11 of the first semiconductor layer 232_1 in the first direction DR1 may be substantially equal to the distance between the first portion 236a_1 of the first well region 236a and the first portion 236b_1 of the second well region 236b in the first direction DR1. The width D21 of the second semiconductor layer 232_2 in the first direction DR1 may be substantially equal to the distance between the second portion 236a_2 of the first well region 236a and the second portion 236b_2 of the second well region 236b in the first direction DR1.

In the example embodiment, the doping region 238 may be positioned between the first portion 236a_1 of the first well region 236a and the first portion 236b_1 of the second well region 236b. The doping region 238 may be positioned at the center between the first portion 236a_1 of the first well region 236a and the second portion 236b_2 of the second well region 236b in the first direction DR1. The doping region 238 may be positioned at the center of the upper portion of the first semiconductor layer 232_1.

In the example embodiment, the first well region 236a and the second well region 236b may have a symmetrical structure with respect to a line connecting the substrate 210 and the doping region 238 in the third direction DR3 perpendicular to the upper surface of the substrate 210. The first portion 236a_1 of the first well region 236a and the first portion 236b_1 of the second well region 236b may be closer to the doping region 238 in the third direction DR3 and be spaced farther apart in the first direction DR1, as compared to the second portion 236a_2 of the first well region 236a and the second portion 236b_2 of the second well region 236b.

According to the example embodiment, each of the first well region 236a and the second well region 236b of the semiconductor device 100 may include the first portion 236a_1 or 236b_1 adjacent to the source electrode 173 and the second portion 236a_2 or 236b_2 adjacent to the upper surface of the substrate 210. The distance D11 in the first direction DR1 between the first portion 236a_1 of the first well region 236a and the first portion 236b_1 of the second well region 236b may be longer than the distance D21 in the first direction DR1 between the second portion 236a_2 of the first well region 236a and the second portion 236b_2 of the second well region 236b. Accordingly, when a high voltage is applied to the drain electrode 205, the depletion regions of the second portions 236a_2 and 236b_2 may touch together, thereby being pinched off. Therefore, the voltage which is applied to the pair of high electron mobility transistors T1 and T2 positioned on the semiconductor layer 232 may be prevented from rising further, such that the semiconductor device 100 can operate at high voltage.

According to the example embodiment, the side surfaces of the first portion 236a_1 or 236b_1 which is positioned between the gate electrode 155 and the connection electrode 175 may be closer to the connection electrode 175 than the side surface of the gate electrode 155 facing the connection electrode 175 is. Accordingly, the first portion 236a_1 or 236b_1 may reduce leakage current of the gate electrode 155.

According to the example embodiment, the semiconductor device 100 may include the substrate 210, the drain electrode 205 below the substrate 210, the semiconductor layer 232 on the substrate 210, and the pair of high electron mobility transistors T1 and T2 on the semiconductor layer 232. Inside the semiconductor layer 232, the first well region 236a and the second well region 236b having a conductivity type different from that of the semiconductor layer 232 may be positioned, and between the first well region 236a and the second well region 236b, the doping region 238 having the same conductivity type as that of the semiconductor layer 232 and a doping concentration higher than that of the semiconductor layer 232 may be positioned. The substrate 210, the semiconductor layer 232, the first well region 236a, the second well region 236b, and the doping region 238 may contain the first semiconductor material, and the channel layer 132 of the pair of high electron mobility transistors T1 and T2 may contain the second semiconductor material having electron mobility higher than that of the first semiconductor material. The first semiconductor material may be SiC, and the second semiconductor material may be GaN. The source electrode 173 of the pair of high electron mobility transistors T1 and T2 may be connected to each of the first well region 236a and the second well region 236b. The connection electrode 175 of the pair of high electron mobility transistors T1 and T2 may be connected to the doping region 238.

In the semiconductor device 100 according to the example embodiment, the pair of high electron mobility transistors T1 and T2 may serve as a switch, and the first well region 236a and the second well region 236b may reduce leakage current and improve the breakdown voltage of the semiconductor device 100. Accordingly, the semiconductor device 100 having an improved switching speed while withstanding high voltage can be provided. Further, the distance between the connection electrode 175 and the gate electrode 155 of each of the pair of high electron mobility transistors T1 and T2 does not need to be long to improve the breakdown voltage, so the resistance of the channel layer 132 may decrease, and it is possible to reduce the size of the semiconductor device 100. Furthermore, it is not necessary to form a field dispersion layer for covering the gate electrode 155 of each of the pair of high electron mobility transistors T1 and T2 to prevent an electric field from being concentrated around the gate electrode 155, so design of the semiconductor device 100 may become easier.

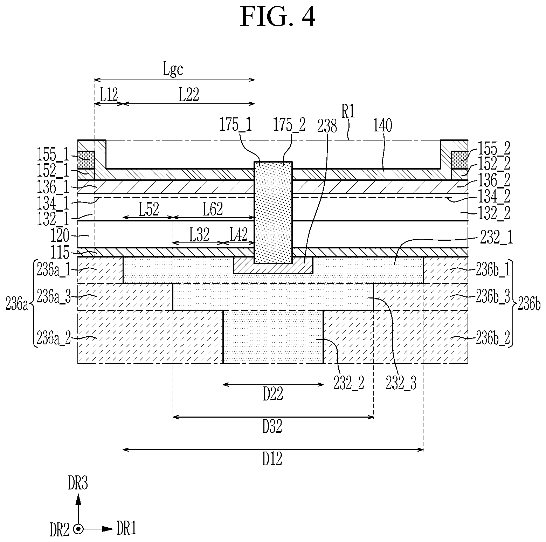

Subsequently, a semiconductor device according to an example embodiment will be described with reference to FIGS. 4 to 6.

Each of FIGS. 4 to 6 is a cross-sectional view illustrating a semiconductor device according to an example embodiment.

FIGS. 4 to 6 illustrate various modifications of the semiconductor device according to the example embodiment shown in FIGS. 1 to 3. FIGS. 4 to 6 are enlarged views of a region corresponding to the region R1 of FIG. 2. Since the example embodiment shown in FIGS. 4 to 6 have many portions identical to those of the example embodiment shown in FIGS. 1 to 3, a description thereof will not be made and the differences will be mainly described. Also, constituent elements identical to those of the above example embodiment are denoted by the same reference symbols. The example embodiment shown in FIGS. 4 to 6 may be partially different from the previous example embodiment in the shapes of the first well region 236a and the second well region 236b and the like.

As shown in FIG. 4, the first well region 236a may include a first portion 236a_1 adjacent to the first source electrode 173_1, a second portion 236a_2 adjacent to the upper surface of the substrate 210, and a third portion 236a_3 that is positioned between the first portion 236a_1 and the second portion 236a_2. The second well region 236b may include a first portion 236b_1 adjacent to the second source electrode 173_2, a second portion 236b_2 adjacent to the upper surface of the substrate 210, and a third portion 236b_3 that is positioned between the first portion 236b_1 and the second portion 236b_2. Hereinafter, a description will be made with a focus on the first well region 236a, and the first portion 236a_1, the second portion 236a_2, and the third portion 236a_3 of the first well region 236a. In respect to the second well region 236b, and the first portion 236b_1, the second portion 236b_2, and the third portion 236b_3 of the second well region 236b, the description of the first well region 236a, and the first portion 236a_1, the second portion 236a_2, and the third portion 236a_3 of the first well region 236a may be equally or similarly applied.

In the example embodiment, the side surface of the first well region 236a which is positioned between the first gate electrode 155_1 and the first connection electrode 175_1 may have a step shape that declines as it approaches the first connection electrode 175_1 from the first gate electrode 155_1 along the first direction DR1.

In the example embodiment, the first well region 236a may include the first portion 236a_1, the third portion 236a_3, and the second portion 236a_2. The third portion 236a_3 may be positioned at a level higher than that of the second portion 236a_2 from the upper surface of the substrate 210. The first portion 236a_1 may be positioned at a level higher than that of the third portion 236a_3 from the upper surface of the substrate 210.

In the example embodiment, each of the side surface of the first portion 236a_1, the side surface of the third portion 236a_3, and the side surface of the second portion 236a_2 may extend in the third direction DR3 perpendicular to the upper surface of the substrate 210. On a cross section along the first direction DR1 and the third direction DR3, each of the side surface of the first portion 236a_1, the side surface of the third portion 236a_3, and the side surface of the second portion 236a_2 may be a straight line.

In the example embodiment, the side surface of the first portion 236a_1, which is positioned between the first gate electrode 155_1 and the first connection electrode 175_1, may be closer to the first connection electrode 175_1 than the side surface of the first gate electrode 155_1 is in the first direction DR1. In other words, the distance L12 in the first direction DR1 between the side surface of the first gate electrode 155_1 facing the first connection electrode 175_1 and the side surface of the first portion 236a_1 which is positioned between the first gate electrode 155_1 and the first connection electrode 175_1 may be greater than 0. The distance L22 in the first direction DR1 between the side surface of the first portion 236a_1 which is positioned between the first gate electrode 155_1 and the first connection electrode 175_1 and the side surface of the first connection electrode 175_1 may be shorter than the distance Lgc in the first direction DR1 between the side surfaces of the first gate electrode 155_1 and the first connection electrode 175_1 facing each other. The distance Lgc corresponds to the sum of the distance L12 and the distance L22.

In the example embodiment, the side surface of the third portion 236a_3, which is positioned between the first gate electrode 155_1 and the first connection electrode 175_1, may be closer to the first connection electrode 175_1 than the side surface of the first portion 236a_1, which is positioned between the first gate electrode 155_1 and the first connection electrode 175_1 is, in the first direction DR1. In other words, the distance L52 in the first direction DR1 between the side surface of the first portion 236a_1 which is positioned between the first gate electrode 155_1 and the first connection electrode 175_1 and the side surface of the third portion 236a_3 which is positioned between the first gate electrode 155_1 and the first connection electrode 175_1 may be greater than 0. That is, the side surface of the third portion 236a_3 which is positioned between the first gate electrode 155_1 and the first connection electrode 175_1 may be located between the first connection electrode 175_1 and the side surface of the first portion 236a_1, which is positioned between the first gate electrode 155_1 and the first connection electrode 175_1, in the first direction DR1. The distance L62 in the first direction DR1 between the side surface of the third portion 236a_3 which is positioned between the first gate electrode 155_1 and the first connection electrode 175_1 and the side surface of the first connection electrode 175_1 may be shorter than the distance L22 in the first direction DR1 between the first connection electrode 175_1 and the side surface of the first portion 236a_1 which is positioned between the first gate electrode 155_1 and the first connection electrode 175_1. The distance L22 corresponds to the sum of the distance L52 and the distance L62.

In the example embodiment, the side surface of the second portion 236a_2 which is positioned between the first gate electrode 155_1 and the first connection electrode 175_1 may be closer to the first gate electrode 155_1 than the side surface of the third portion 236a_3 which is positioned between the first gate electrode 155_1 and the first connection electrode 175_1 is, in the first direction DR1. In other words, the distance L32 in the first direction DR1 between the side surface of the third portion 236a_3 which is positioned between the first gate electrode 155_1 and the first connection electrode 175_1 and the side surface of the second portion 236a_2 which is positioned between the first gate electrode 155_1 and the first connection electrode 175_1 may be greater than 0. That is, the side surface of the second portion 236a_2 which is positioned between the first gate electrode 155_1 and the first connection electrode 175_1 may be located between the first connection electrode 175_1 and the side surface of the third portion 236a_3, which is positioned between the first gate electrode 155_1 and the first connection electrode 175_1, in the first direction DR1. The distance L42 in the first direction DR1 between side surface of the second portion 236a_2 which is positioned between the first gate electrode 155_1 and the first connection electrode 175_1 and the side surface of the first connection electrode 175_1 may be shorter than the distance L62 in the first direction DR1 between the side surface of the third portion 236a_3 which is positioned between the first gate electrode 155_1 and the first connection electrode 175_1 and the side surface of the first connection electrode 175_1. The sum of the distance L32 and the distance L42 corresponds to the distance L62.

In the example embodiment, the distance D32 in the first direction DR1 between the third portion 236a_3 of the first well region 236a and the third portion 236b_3 of the second well region 236b may be shorter than the distance D12 in the first direction DR1 between the first portion 236a_1 of the first well region 236a and the first portion 236b_1 of the second well region 236b, and longer than the distance D22 between the second portion 236a_2 of the first well region 236a and the second portion 236b_2 of the second well region 236b in the first direction DR1.

In the example embodiment, the semiconductor layer 232 may be positioned on the side surface of the first portion 236a_1, the side surface and upper surface of the third portion 236a_3, and the side surface and upper surface of the second portion 236a_2 which are positioned between the first gate electrode 155_1 and the first connection electrode 175_1. The semiconductor layer 232 may be positioned between the upper surface of the third portion 236a_3 and the channel layer 132_1 and between the upper surface of the second portion 236a_2 and the channel layer 132_1, and may not be positioned between the upper surface of the first portion 236a_1 and the channel layer 132_1. In other words, a portion of the semiconductor layer 232 may be positioned in the third direction DR3 between the upper surface of the third portion 236a_3 and the channel layer 132_1 and between the upper surface of the second portion 236a_2 and the lower surface of the channel layer 132_1.

In the example embodiment, the semiconductor layer 232 may include a first semiconductor layer 232_1 which is positioned between the first portion 236a_1 of the first well region 236a and the first portion 236b_1 of the second well region 236b, a second semiconductor layer 232_2 which is positioned between the second portion 236a_2 of the first well region 236a and the second portion 236b_2 of the second well region 236b, and a third semiconductor layer 232_3 which is positioned between the third portion 236a_3 of the first well region 236a and the third portion 236b_3 of the second well region 236b. The third semiconductor layer 232_3 may be positioned between the first semiconductor layer 232_1 and the second semiconductor layer 232_2. The width D32 of the third semiconductor layer 232_3 in the first direction DR1 may be shorter than the width D12 of the first semiconductor layer 232_1 in the first direction DR1, and larger than the width D22 of the second semiconductor layer 232_2 in the first direction DR1.

In the example embodiment, the third portion 236a_3 of the first well region 236a and the third portion 236b_3 of the second well region 236b may be closer to the doping region 238 in the third direction DR3 and may be spaced farther apart in the first direction DR1, as compared to the second portion 236a_2 of the first well region 236a and the second portion 236b_2 of the second well region 236b. The first portion 236a_1 of the first well region 236a and the first portion 236b_1 of the second well region 236b may be closer to the doping region 238 in the third direction DR3 and may be spaced farther apart in the first direction DR1, as compared to the third portion 236a_3 of the first well region 236a and the third portion 236b_3 of the second well region 236b.

According to the example embodiment, each of the first well region 236a and the second well region 236b of the semiconductor device 100 may include the first portion 236a_1 or 236b_1 adjacent to the source electrode 173, the second portion 236a_2 or 236b_2 adjacent to the upper surface of the substrate 210, and the third portion 236a_3 or 236b_3 that is positioned between the first portion 236a_1 or 236b_1 and the second portion 236a_2 or 236b_2. The distance in the first direction DR1 between the third portion 236a_3 of the first well region 236a and the third portion 236b_3 of the second well region 236b may be shorter than the distance in the first direction DR1 between the first portion 236a_1 of the first well region 236a and the first portion 236b_1 of the second well region 236b, and longer than the distance between the second portion 236a_2 of the first well region 236a and the second portion 236b_2 of the second well region 236b in the first direction DR1.

In the example embodiment of FIG. 4, unlike in the example embodiment of FIGS. 2 and 3, each of the first well region 236a and the second well region 236b may include three portions in the separation distance in the first direction DR1 between the first well region 236a and the second well region 236b; however, the present disclosure is not limited thereto. The number of portions which are included in each of the first well region 236a and the second well region 236b may be variously changed. The separation distance between the first well region 236a and the second well region 236b in the first direction DR1 may be shorter at a portion closer to the upper surface of the substrate 210 (or, at a portion farther from the doping region 238 in the third direction DR3) among the plurality of portions of each of the first well region 236a and the second well region 236b. The side surface of a portion of each of the first well region 236a and the second well region 236b which is positioned between the gate electrode 155 and the connection electrode 175 and is closest to the source electrode 173 may be closer to the connection electrode 175 than the side surface of the gate electrode 155.

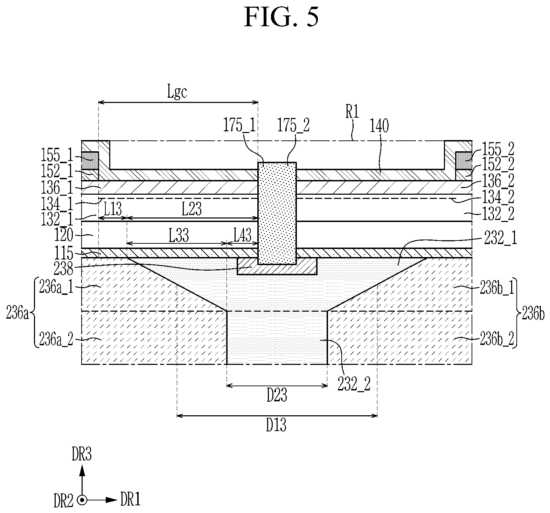

As shown in FIG. 5, the first well region 236a may include a first portion 236a_1 adjacent to the first source electrode 173_1, and a second portion 236a_2 adjacent to the upper surface of the substrate 210. The second well region 236b may include a first portion 236b_1 adjacent to the second source electrode 173_2, and a second portion 236b_2 adjacent to the upper surface of the substrate 210. Hereinafter, a description will be made with a focus on the first well region 236a, and the first portion 236a_1 and second portion 236a_2 of the first well region 236a. In respect to the second well region 236b, and the first portion 236b_1 and second portion 236b_2 of the second well region 236b, the description of the first well region 236a, and the first portion 236a_1 and second portion 236a_2 of the first well region 236a may be equally or similarly applied.

In the example embodiment, the side surface of the first well region 236a which is positioned between the first gate electrode 155_1 and the first connection electrode 175_1 may decline as it approaches the first connection electrode 175_1 from the first gate electrode 155_1 along the first direction DR1.

In the example embodiment, the side surface of the first portion 236a_1 may extend in a direction intersecting the first direction DR1 and the third direction DR3. The side surface of the first portion 236a_1 may connect the upper surface of the first portion 236a_1 and the side surface of the second portion 236a_2 and have a predetermined inclination. The side surface of the first portion 236a_1 may be an inclined surface declining as it approaches the first connection electrode 175_1 from the first gate electrode 155_1 along the first direction DR1. For instance, the distance in the first direction DR1 between the side surface of the first portion 236a_1 and the first connection electrode 175_1 may decrease as the side surface of the first portion 236a_1 gets closer to the second portion 236a_2.

In the example embodiment, the side surface of the second portion 236a_2 may extend in the third direction DR3 perpendicular to the upper surface of the substrate 210. However, the present disclosure is not limited thereto, and the side surface of the second portion 236a_2 may be an inclined surface declining as it approaches the first connection electrode 175_1 from the side surface of the first portion 236a_1 along the first direction DR1. In this case, the inclination of the side surface of the second portion 236a_2 may be larger than the inclination of the side surface of the first portion 236a_1.

In the example embodiment, the side surface of the first portion 236a_1 which is positioned between the first gate electrode 155_1 and the first connection electrode 175_1 may be closer to the first connection electrode 175_1 than the first gate electrode 155_1 is in the first direction DR1. In other words, the distance L13 (e.g. the maximum distance) in the first direction DR1 between the side surface (e.g. the top of the side surface) of the first gate electrode 155_1 facing the first connection electrode 175_1 and the side surface of the first portion 236a_1 which is positioned between the first gate electrode 155_1 and the first connection electrode 175_1 may be larger than 0. The distance L23 (e.g. the maximum distance) in the first direction DR1 between the side surface (e.g. the top of the side surface) of the first portion 236a_1 which is positioned between the first gate electrode 155_1 and the first connection electrode 175_1 and the side surface of the first connection electrode 175_1 may be shorter than the distance Lgc in the first direction DR1 between the side surfaces of the first gate electrode 155_1 and the first connection electrode 175_1 facing each other. The sum of the distance L13 and the distance L23 corresponds to the distance Lgc.

In the example embodiment, the side surface of the second portion 236a_2 which is positioned between the first gate electrode 155_1 and the first connection electrode 175_1 may be closer to the first connection electrode 175_1 than the side surface of the first portion 236a_1 which is positioned between the first gate electrode 155_1 and the first connection electrode 175_1 is, in the first direction DR1. In other words, the distance L33 in the first direction DR1 between the side surface of the first portion 236a_1 which is positioned between the first gate electrode 155_1 and the first connection electrode 175_1 and the side surface of the second portion 236a_2 which is positioned between the first gate electrode 155_1 and the first connection electrode 175_1 may be larger than 0. The distance L43 in the first direction DR1 between the side surface of the second portion 236a_2 which is positioned between the first gate electrode 155_1 and the first connection electrode 175_1 and the side surface of the first connection electrode 175_1 may be shorter than the distance L23 in the first direction DR1 between the first connection electrode 175_1 and the side surface of the first portion 236a_1 which is positioned between the first gate electrode 155_1 and the first connection electrode 175_1. The sum of the distance L33 and L43 corresponds to the distance L23.

In the example embodiment, the distance D13 in the first direction DR1 between the first portion 236a_1 of the first well region 236a and the first portion 236b_1 of the second well region 236b may decrease as it approaches the upper surface of the substrate 210. The distance D13 may have a decreasing distance toward the upper surface of the substrate 210. For example, the distance D13 may decrease from the maximum distance of the distance D13 to the shortest distance of the distance D13, which corresponds to the maximum distance of the distance D23. The distance D13 in the first direction DR1 between the first portion 236a_1 of the first well region 236a and the first portion 236b_1 of the second well region 236b may be longer than the distance D23 between the second portion 236a_2 of the first well region 236a and the second portion 236b_2 of the second well region 236b in the first direction DR1.

In the example embodiment, the semiconductor layer 232 may be positioned on the side surface of the first portion 236a_1 and the side surface of the second portion 236a_2 which are positioned between the first gate electrode 155_1 and the first connection electrode 175_1. The semiconductor layer 232 may be positioned between the side surface of the first portion 236a_1 and the channel layer 132_1, and may not be positioned between the upper surface of the first portion 236a_1 and the channel layer 132_1. In other words, a portion of the semiconductor layer 232 may be positioned in the third direction DR3 between the side surface of the first portion 236a_1 and the lower surface of the channel layer 132_1.

In the example embodiment, the semiconductor layer 232 may include a first semiconductor layer 232_1 which is positioned between the first portion 236a_1 of the first well region 236a and the first portion 236b_1 of the second well region 236b, and a second semiconductor layer 232_2 which is positioned between the second portion 236a_2 of the first well region 236a and the second portion 236b_2 of the second well region 236b.

In the example embodiment, the width D13 of the first semiconductor layer 232_1 in the first direction DR1 may decrease as it approaches the upper surface of the substrate 210. The width D13 of the first semiconductor layer 232_1 in the first direction DR1 may be larger than the width D23 of the second semiconductor layer 232_2 in the first direction DR1.

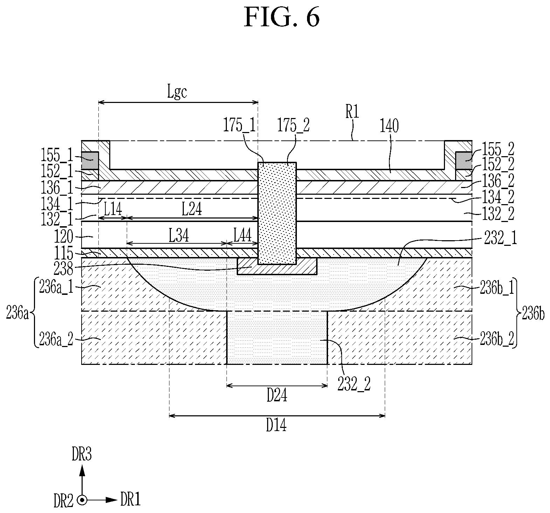

As shown in FIG. 6, the first well region 236a may include the first portion 236a_1 adjacent to the first source electrode 173_1, and the second portion 236a_2 adjacent to the upper surface of the substrate 210. The second well region 236b may include the first portion 236b_1 adjacent to the second source electrode 173_2, and the second portion 236b_2 adjacent to the upper surface of the substrate 210. Hereinafter, a description will be made with a focus on the first well region 236a, and the first portion 236a_1 and second portion 236a_2 of the first well region 236a. In respect to the second well region 236b, and the first portion 236b_1 and second portion 236b_2 of the second well region 236b, the description of the first well region 236a, and the first portion 236a_1 and second portion 236a_2 of the first well region 236a may be equally or similarly applied.

In the example embodiment, the side surface of the first well region 236a which is positioned between the first gate electrode 155_1 and the first connection electrode 175_1 may decline as it approaches the first connection electrode 175_1 from the first gate electrode 155_1 along the first direction DR1.

In the example embodiment, the side surface of the first portion 236a_1 may include a curved surface. The side surface of the first portion 236a_1 may connect the upper surface of the first portion 236a_1 to the side surface of the second portion 236a_2, and its inclination (e.g. slope) may differ depending on the height from the upper surface of the substrate 210. The inclination of the side surface of the first portion 236a_1 or 236b_1 may decrease as it approaches the upper surface of the substrate 210. In this context, the inclination may relate to an angle relative to the first direction DR1. Accordingly, the slope of the side surface (e.g. the rate of change in the first direction DR1 relative to the third direction DR3) of the first portion 236a_1 or 236b_1 may decrease as it approaches the upper surface of the substrate 210. The side surface of the first portion 236a_1 or 236b_1 may be steeper at its top than at its bottom.

In the example embodiment, the side surface of the second portion 236a_2 may be a flat surface. The side surface of the second portion 236a_2 may extend in the third direction DR3 perpendicular to the upper surface of the substrate 210. However, the present disclosure is not limited thereto, and the side surface of the second portion 236a_2 may be an inclined surface declining as it approaches the first connection electrode 175_1 from the side surface of the first portion 236a_1 along the first direction DR1, or may be a curved surface whose inclination (e.g. slope) decreases as it approaches the first connection electrode 175_1 from the side surface of the first portion 236a_1 along the first direction DR1.

In the example embodiment, the side surface of the first portion 236a_1 which is positioned between the first gate electrode 155_1 and the first connection electrode 175_1 may be closer to the first connection electrode 175_1 than the first gate electrode 155_1 is, in the first direction DR1. In other words, the distance L14 (e.g. the maximum distance) in the first direction DR1 between the side surface of the first gate electrode 155_1 facing the first connection electrode 175_1 and the side surface (e.g. the top of the side surface) of the first portion 236a_1 which is positioned between the first gate electrode 155_1 and the first connection electrode 175_1 may be greater than 0. The distance L24 (e.g. the maximum distance) in the first direction DR1 between the side surface (e.g. the top of the side surface) of the first portion 236a_1 which is positioned between the first gate electrode 155_1 and the first connection electrode 175_1 and the side surface of the first connection electrode 175_1 may be shorter than the distance Lgc in the first direction DR1 between the side surfaces of the first gate electrode 155_1 and the first connection electrode 175_1 facing each other. The distance Lgc corresponds to the sum of the distance L14 and the distance L24.

In the example embodiment, the side surface of the second portion 236a_2 which is positioned between the first gate electrode 155_1 and the first connection electrode 175_1 may be closer to the first connection electrode 175_1 than the side surface of the first portion 236a_1 which is positioned between the first gate electrode 155_1 and the first connection electrode 175_1 is, in the first direction DR1. In other words, the distance L34 in the first direction DR1 between the side surface of the first portion 236a_1 which is positioned between the first gate electrode 155_1 and the first connection electrode 175_1 and the side surface of the second portion 236a_2 which is positioned between the first gate electrode 155_1 and the first connection electrode 175_1 may be greater than 0. The distance L44 in the first direction DR1 between the side surface of the second portion 236a_2 which is positioned between the first gate electrode 155_1 and the first connection electrode 175_1 and the side surface of the first connection electrode 175_1 may be shorter than the distance L24 (e.g. the maximum distance) in the first direction DR1 between the first connection electrode 175_1 and the side surface (e.g. the top of the side surface) of the first portion 236a_1 which is positioned between the first gate electrode 155_1 and the first connection electrode 175_1. The sum of the distance L34 and the distance L44 corresponds to the distance L24.

In the example embodiment, the distance D14 in the first direction DR1 between the first portion 236a_1 of the first well region 236a and the first portion 236b_1 of the second well region 236b may decrease as it approaches the upper surface of the substrate 210. The distance D14 in the first direction DR1 between the first portion 236a_1 of the first well region 236a and the first portion 236b_1 of the second well region 236b may be longer than the distance D24 in the first direction DR1 between the second portion 236a_2 of the first well region 236a and the second portion 236b_2 of the second well region 236b. The sum of the distance L14 and the distance L24 corresponds to the distance Lgc.

In the example embodiment, the semiconductor layer 232 may be positioned on the side surface of the first portion 236a_1 and the side surface of the second portion 236a_2 which are positioned between the first gate electrode 155_1 and the first connection electrode 175_1. The semiconductor layer 232 may be positioned between the side surface of the first portion 236a_1 and the channel layer 132_1, and may not be positioned between the upper surface of the first portion 236a_1 and the channel layer 132_1. In other words, a portion of the semiconductor layer 232 may be positioned in the third direction DR3 between the side surface of the first portion 236a_1 and the lower surface of the channel layer 132_1.

In the example embodiment, the semiconductor layer 232 may include a first semiconductor layer 232_1 which is positioned between the first portion 236a_1 of the first well region 236a and the first portion 236b_1 of the second well region 236b, and a second semiconductor layer 232_2 which is positioned between the second portion 236a_2 of the first well region 236a and the second portion 236b_2 of the second well region 236b.

In the example embodiment, the width D14 of the first semiconductor layer 232_1 in the first direction DR1 may decrease as it approaches the upper surface of the substrate 210. The width D14 of the first semiconductor layer 232_1 in the first direction DR1 may be larger than the width D24 of the second semiconductor layer 232_2 in the first direction DR1.

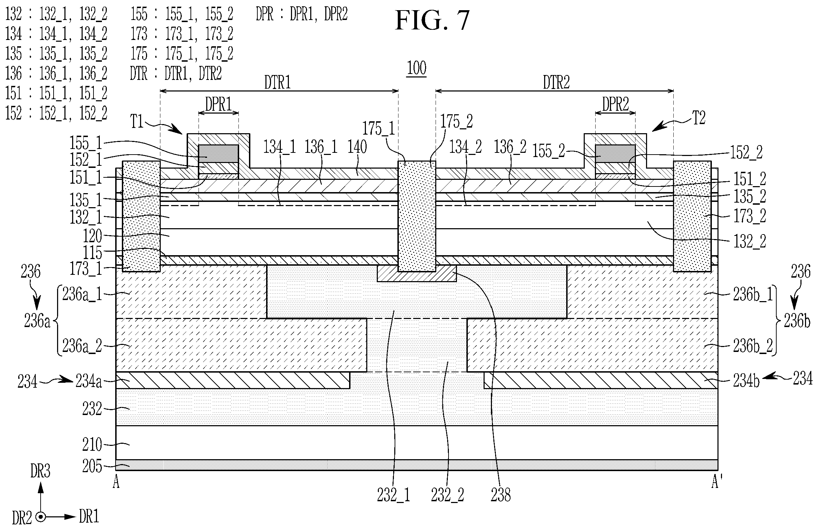

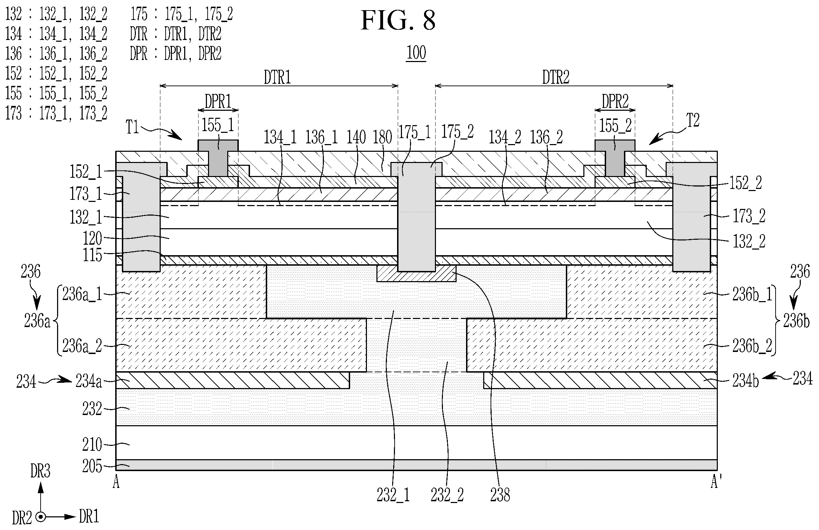

Subsequently, a semiconductor device according to an example embodiment will be described with reference to FIGS. 7 and 8.

Each of FIGS. 7 and 8 is a cross-sectional view illustrating a semiconductor device according to an example embodiment.

FIGS. 7 and 8 illustrate various modifications of the semiconductor device according to the example embodiment shown in FIGS. 1 to 3. FIGS. 7 and 8 are cross-sectional views taken along line A-A' of FIG. 1. Since the example embodiment shown in FIGS. 7 and 8 have many portions identical to those of the example embodiment shown in FIGS. 1 to 3, a description thereof will not be made and the differences will be mainly described. Also, constituent elements identical to those of the above example embodiment are denoted by the same reference symbols. The example embodiment shown in FIG. 7 may be partially different from the above example embodiment in that it further includes a spacer layer 135 and a gate barrier layer 151. The example embodiment shown in FIG. 8 may be partially different from the above example embodiment in that it further includes a second protective layer 180.

As shown in FIG. 7, the spacer layer 135 may be positioned between the channel layer 132 and the barrier layer 136. The spacer layer 135 may include a first spacer layer 135_1 that is positioned between the first channel layer 132_1 and the first barrier layer 136_1, and a second spacer layer 135_2 that is positioned between the second channel layer 132_2 and the second barrier layer 136_2.

The spacer layer 135 may cover the upper surface of the channel layer 132. The barrier layer 136 may be positioned on the spacer layer 135. The barrier layer 136 may be spaced apart from the channel layer 132 by the spacer layer 135. The spacer layer 135 may prevent carriers passing through the 2-dimensional electron gas 134 of the channel layer 132 from migrating up to the barrier layer 136. Since the spacer layer 135 lowers the level of the energy band of the interface of the barrier layer 136 and the channel layer 132, thereby enhancing the 2-dimensional electron gas 134, it is possible to increase the density of carriers.

In the example embodiment shown in FIG. 7, unlike in the example embodiment shown in FIGS. 1 to 3, the source electrode 173 and the connection electrode 175 may further pass through the spacer layer 135.

The spacer layer 135 may contain a material having an energy band gap different from that of the barrier layer 136. For example, the barrier layer 136 may contain AlGaN, and the spacer layer 135 may contain AlN.

Further, the gate barrier layer 151 may be positioned between the barrier layer 136 and the gate semiconductor layer 152. The barrier layer 136 may include a first gate barrier layer 151_1 that is positioned between the first barrier layer 136_1 and the first gate semiconductor layer 152_1, and a second gate barrier layer 151_2 that is positioned between the second barrier layer 136_2 and the second gate semiconductor layer 152_2.

The gate barrier layer 151 may be positioned on the barrier layer 136. The gate semiconductor layer 152 may be positioned on the gate barrier layer 151. On the gate semiconductor layer 152, the gate electrode 155 may be positioned. The gate electrode 155 may be in contact with the gate semiconductor layer 152. The lower surface of the gate electrode 155 may be in contact with the gate semiconductor layer 152. The lower surface of the gate semiconductor layer 152 may be in contact with the gate barrier layer 151. The lower surface of the gate barrier layer 151 may be in contact with the barrier layer 136. By the gate barrier layer 151 which is positioned between the gate semiconductor layer 152 and the barrier layer 136, the threshold voltage of the semiconductor device may be increased.

The gate barrier layer 151 may overlap the gate semiconductor layer 152 and the gate electrode 155 in the third direction DR3. The third direction DR3 may be a direction perpendicular to the upper surface of the channel layer 132. The gate barrier layer 151 may be patterned using the same mask as that for the gate semiconductor layer 152 and the gate electrode 155. Accordingly, the gate barrier layer 151 may have substantially the same plane shape as that of the gate semiconductor layer 152 and the gate electrode 155. The gate barrier layer 151 may have substantially the same width as that of the gate semiconductor layer 152 and the gate electrode 155 in the first direction DR1.

The gate barrier layer 151 may contain III-V materials, for example, one or more materials selected from nitrides containing at least one material of Al, Ga, In, and B. The gate barrier layer 151 may be formed of AlₓIn_{y}Ga_{1-x-y}N (wherein 0≤x≤1, 0≤y≤1, and x+y≤1). For example, the gate barrier layer 151 may contain at least one of AlN, GaN, InN, InGaN, AlGaN, AlInN, and AlInGaN. The gate barrier layer 151 may contain a material having an energy band gap different from that of the barrier layer 136. For example, the gate semiconductor layer 152 may contain GaN, and the gate barrier layer 151 may contain AlGaN. The gate barrier layer 151 may be doped with a predetermined impurity. In this case, the impurity with which the gate barrier layer 151 is doped may be a p-type impurity. The dominant charge carriers of the gate barrier layer 151 doped with a p-type impurity are holes. For example, the gate barrier layer 151 may contain AlGaN doped with a p-type impurity. In other words, the gate barrier layer 151 may consist of a p-AlGaN layer. For example, the impurity with which the gate barrier layer 151 is doped may be magnesium (Mg).

As shown in FIG. 8, the first protective layer 140 may be positioned on the barrier layer 136. The source electrode 173 may pass through the first protective layer 140, the barrier layer 136, the channel layer 132, the buffer layer 120, and the seed layer 115, and be connected to the first well region 236a and the second well region 236b. The connection electrode 175 may pass through the first protective layer 140, the barrier layer 136, the channel layer 132, the buffer layer 120, and the seed layer 115, and be connected to the doping region 238. The semiconductor device according to the example embodiment may further include the second protective layer 180 which is positioned on the first protective layer 140, the source electrode 173, and the connection electrode 175. The upper surface of the first protective layer 140 may be covered by the second protective layer 180. The upper surfaces and side surfaces of the source electrode 173 and the connection electrode 175 may be covered by the second protective layer 180. The gate electrode 155 may pass through the first protective layer 140 and the second protective layer 180, and be connected to the gate semiconductor layer 152. A portion of the gate electrode 155 may be positioned on the upper surface of the second protective layer 180.

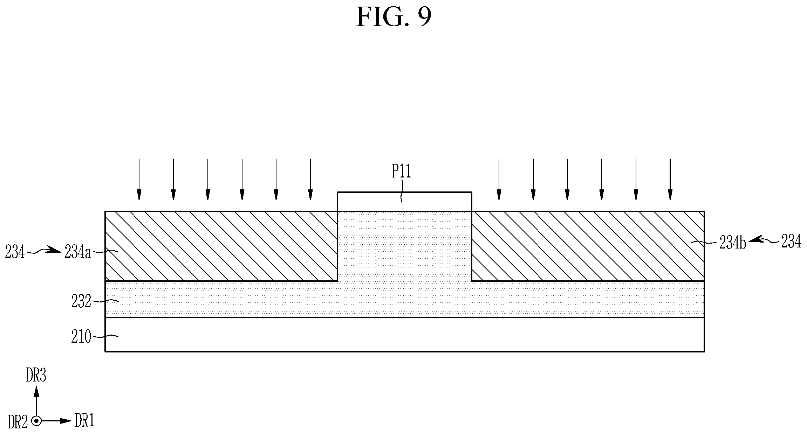

Subsequently, a method of manufacturing a semiconductor device according to an example embodiment will be described with reference to FIGS. 9 to 20.

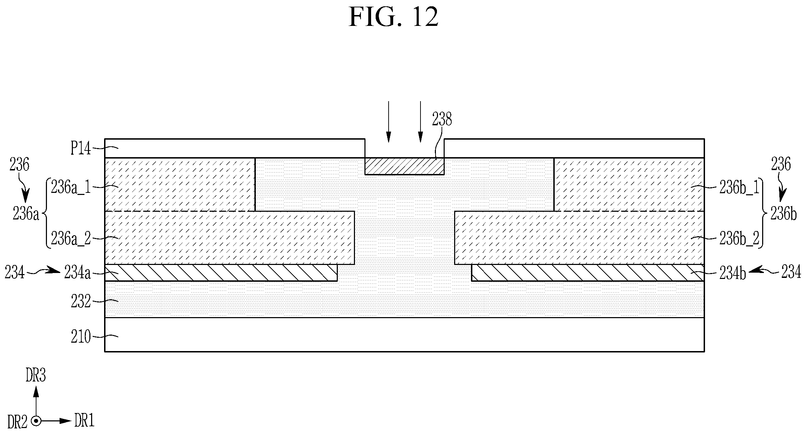

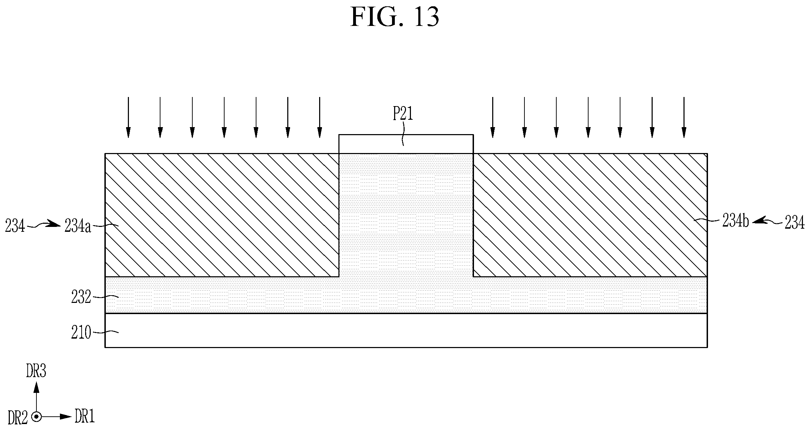

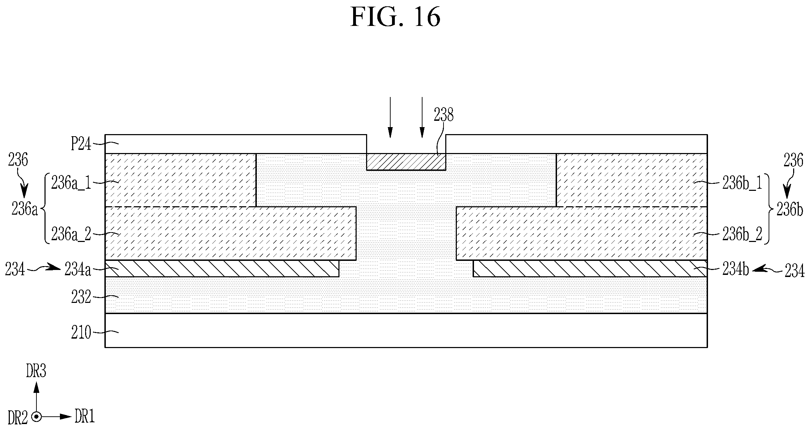

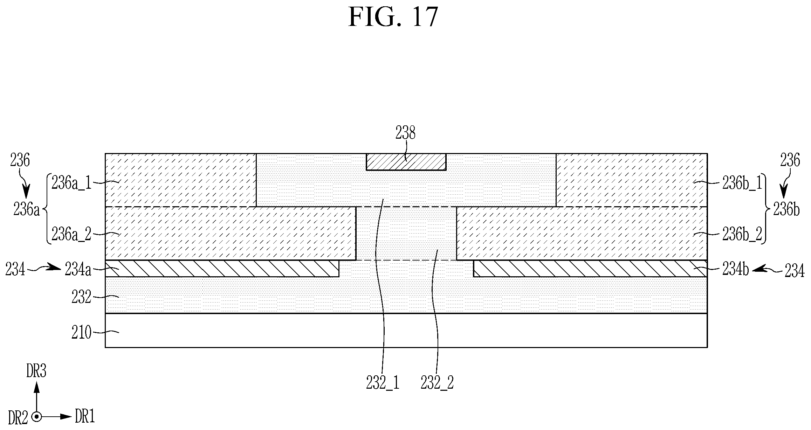

FIGS. 9 to 12 are cross-sectional views illustrating processes of manufacturing a semiconductor device according to an example embodiment in the order of the processes. FIGS. 13 to 16 are cross-sectional views illustrating processes of manufacturing a semiconductor device according to an example embodiment in the order of the processes. FIGS. 17 to 20 are cross-sectional views illustrating processes of manufacturing a semiconductor device according to an example embodiment in the order of the processes, and are views illustrating the processes which are performed after the process of FIG. 12 or the process of FIG. 16.

As shown in FIG. 9, a semiconductor layer 232 may be formed on the substrate 210, and a doping layer 234 may be formed in the upper portion of the semiconductor layer 232.

The substrate 210 may be a semiconductor substrate containing SiC. For example, the substrate 210 may consist of a 4H SiC substrate. The conductivity type of the substrate 210 may be the first conductivity type (e.g. n-type) in which the concentration of electrons is greater than that of holes. The substrate 210 may be doped with an n-type impurity at a high concentration. The substrate 210 may have the first surface and the second surface facing away from each other (e.g. opposite to each other). The first surface of the substrate 210 may be the upper surface, and the second surface of the substrate 210 may be the lower surface.

The semiconductor layer 232 may be formed on the first surface of the substrate 210, i.e., the upper surface by an epitaxial growth method. The semiconductor layer 232 may be formed directly on the substrate 210, or other predetermined layers may be formed on the substrate 210 and then the semiconductor layer 232 may be formed thereon. The semiconductor layer 232 may contain SiC. For example, the semiconductor layer 232 may contain 4H SiC. The doping type of the semiconductor layer 232 may be the same first conductivity type as the doping type of the substrate 210. The dopant of the semiconductor layer 232 may be the same as the dopant of the substrate 210, or may be different from the dopant of the substrate 210. The doping concentration of the semiconductor layer 232 may be lower than the doping concentration of the substrate 210. The semiconductor layer 232 may be doped with an n-type impurity at a low concentration (e.g. a concentration lower than the doping concentration of the substrate 210). For example, the doping concentration of the semiconductor layer 232 may be equal to or higher than about 1×10¹⁵ cm⁻³ and equal to or lower than about 1×10¹⁷ cm⁻³.

Subsequently, in the upper portion of the semiconductor layer 232, the doping layer 234 may be formed. In the example embodiment, the doping layer 234 may include the first doping layer 234a and the second doping layer 234b which are spaced apart from each other in the first direction DR1.

The doping layer 234 may be formed by ion implantation process (IIP). First, a first photoresist pattern P11 may be formed on the upper surface of the semiconductor layer 232 using a photolithography process, thereby defining a region where the doping layer 234 will be formed. For example, a region corresponding to an opening of the first photoresist pattern P11 may be defined as a region where the doping layer 234 will be formed. Thereafter, ions may be implanted into the corresponding region. The doping layer 234 may have a predetermined depth. In this case, the depth of the doping layer 234 may be determined by the number of ions which are implanted and/or the speed at which the ions are accelerated.

The doping layer 234 may contain SiC. For example, the doping layer 234 may contain 4H SiC. The doping layer 234 and the semiconductor layer 232 have the same first conductivity type. The doping layer 234 may be doped with an n-type impurity. The doping concentration of the doping layer 234 may be higher than that of the semiconductor layer 232. For example, the doping concentration of the doping layer 234 may be equal to or higher than about 1×10¹⁷ cm⁻³ and equal to or lower than about 1×10¹⁹ cm⁻³. The material, doping type, doping concentration, and the like of the doping layer 234 are not limited thereto, and may be variously changed.

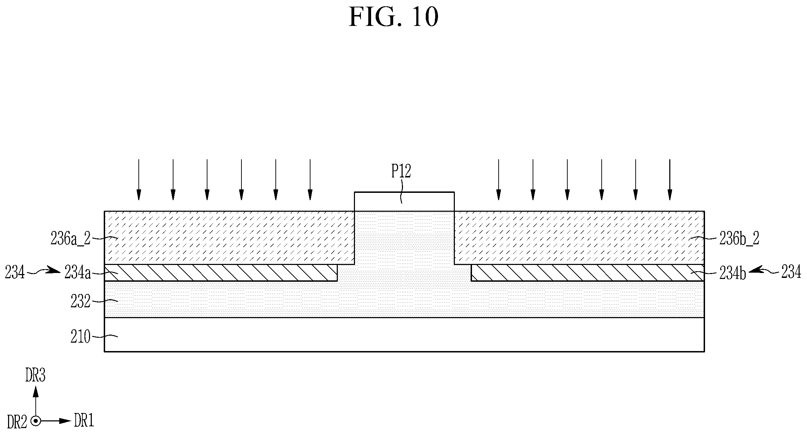

As shown in FIG. 10, the second portions 236a_2 and 236b_2 of the first well region 236a and the second well region 236b may be formed on the doping layer 234. In the example embodiment, the second portion 236a_2 of the first well region 236a may be formed on the first doping layer 234a, and the second portion 236b_2 of the second well region 236b may be formed on the second doping layer 234b. The second portion 236a_2 of the first well region 236a and the second portion 236b_2 of the second well region 236b may be spaced apart from each other in the first direction DR1. The separation distance between the second portion 236a_2 of the first well region 236a and the second portion 236b_2 of the second well region 236b in the first direction DR1 may be equal to or smaller than the separation distance between the first doping layer 234a and the second doping layer 234b in the first direction DR1.

The second portion 236a_2 of the first well region 236a and the second portion 236b_2 of the second well region 236b may be formed by an ion implantation process. First, a second photoresist pattern P12 may be formed on the upper surface of the semiconductor layer 232 using a photolithography process, thereby defining regions where the second portion 236a_2 of the first well region 236a and the second portion 236b_2 of the second well region 236b will be formed. For example, regions corresponding to openings of the second photoresist pattern P12 may be defined as regions where the second portion 236a_2 of the first well region 236a and the second portion 236b_2 of the second well region 236b will be formed. Thereafter, ions may be implanted into the corresponding regions. The second portion 236a_2 of the first well region 236a and the second portion 236b_2 of the second well region 236b may have a predetermined depth. In this case, the depth of the second portion 236a_2 of the first well region 236a and the second portion 236b_2 of the second well region 236b may be determined by the number of ions which are implanted and/or the speed at which the ions are accelerated.

In the example embodiment, the depth of the second portion 236a_2 of the first well region 236a and the second portion 236b_2 of the second well region 236b may be smaller than the depth of the first doping layer 234a and the second doping layer 234b of FIG. 9. At least a portion of the lower surface of the second portion 236a_2 of the first well region 236a may be covered by the first doping layer 234a, and at least a portion of the lower surface of the second portion 236b_2 of the second well region 236b may be covered by the second doping layer 234b.

The second portion 236a_2 of the first well region 236a and the second portion 236b_2 of the second well region 236b may contain SiC. For example, the second portion 236a_2 of the first well region 236a and the second portion 236b_2 of the second well region 236b may contain 4H SiC. The second portion 236a_2 of the first well region 236a and the second portion 236b_2 of the second well region 236b may be the second conductivity type different from the doping type of the semiconductor layer 232. The second portion 236a_2 of the first well region 236a and the second portion 236b_2 of the second well region 236b may be doped with a p-type impurity. The second portion 236a_2 of the first well region 236a and the second portion 236b_2 of the second well region 236b may be doped with a p-type impurity at a low concentration. The doping concentration of the second portion 236a_2 of the first well region 236a and the second portion 236b_2 of the second well region 236b may be equal to or higher than about 1×10¹⁷ cm⁻³ and equal to or lower than about 1 ×10¹⁹ cm⁻³. The material, doping type, doping concentration, and the like of the second portion 236a_2 of the first well region 236a and the second portion 236b_2 of the second well region 236b are not limited thereto, and may be variously changed.

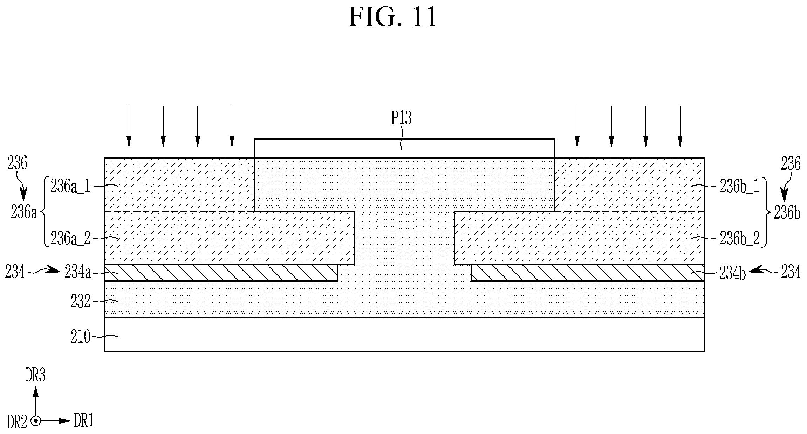

As shown in FIG. 11, on the second portions 236a_2 and 236b_2 of the first well region 236a and the second well region 236b, a semiconductor layer 232 may be additionally formed, and in the upper portion of the additionally formed semiconductor layer 232, the first portions 236a_1 and 236b_1 of the first well region 236a and the second well region 236b may be formed.

On the upper surfaces of the second portions 236a_2 and 236b_2 of the first well region 236a and the second well region 236b and the upper surface of the semiconductor layer 232 between the second portions 236a_2 and 236b_2, a semiconductor layer 232 may be additionally formed using an epitaxial growth method. The additionally formed semiconductor layer 232 may have the same material, doping type, and doping concentration as those of the semiconductor layer 232 shown in FIG. 9.

Subsequently, in the upper portion of the additionally formed semiconductor layer 232, the first portions 236a_1 and 236b_1 of the first well region 236a and the second well region 236b may be formed. In the example embodiment, the first portion 236a_1 of the first well region 236a may be formed on the second portion 236a_2 of the first well region 236a, and the first portion 236b_1 of the second well region 236b may be formed on the second portion 236b_2 of the second well region 236b. The first portion 236a_1 of the first well region 236a and the first portion 236b_1 of the second well region 236b may be spaced apart from each other in the first direction DR1. The separation distance between the first portion 236a_1 of the first well region 236a and the first portion 236b_1 of the second well region 236b in the first direction DR1 may be larger than the separation distance between the second portion 236a_2 of the first well region 236a and the second portion 236b_2 of the second well region 236b in the first direction DR1.

The first portion 236a_1 of the first well region 236a and the first portion 236b_1 of the second well region 236b may be formed by an ion implantation process. First, a third photoresist pattern P13 may be formed on the upper surface of the semiconductor layer 232 using a photolithography process, thereby defining regions where the first portion 236a_1 of the first well region 236a and the first portion 236b_1 of the second well region 236b will be formed. For example, regions corresponding to openings of the third photoresist pattern P13 may be defined as regions where the first portion 236a_1 of the first well region 236a and the first portion 236b_1 of the second well region 236b will be formed. Thereafter, ions may be implanted into the corresponding regions. The first portion 236a_1 of the first well region 236a and the first portion 236b_1 of the second well region 236b may have a predetermined depth. In this case, the depth of the first portion 236a_1 of the first well region 236a and the first portion 236b_1 of the second well region 236b may be determined by the number of ions which are implanted and/or the speed at which the ions are accelerated.

In the example embodiment, the depth of the first portion 236a_1 of the first well region 236a and the first portion 236b_1 of the second well region 236b may be defined from the upper surface of the semiconductor layer 232 to the upper surface of the second portion 236a_2 of the first well region 236a and the second portion 236b_2 of the second well region 236b. The first portion 236a_1 of the first well region 236a may be connected to the second portion 236a_2 of the first well region 236a, and the first portion 236b_1 of the second well region 236b may be connected to the second portion 236b_2 of the second well region 236b.

The first portion 236a_1 of the first well region 236a and the first portion 236b_1 of the second well region 236b may have the same material, doping type, and doping concentration as those of the second portion 236a_2 of the first well region 236a and the second portion 236b_2 of the second well region 236b shown in FIG. 10. However, the present disclosure is not limited thereto, and the first portion 236a_1 of the first well region 236a and the first portion 236b_1 of the second well region 236b may be doped at a higher concentration than that of the second portion 236a_2 of the first well region 236a and the second portion 236b_2 of the second well region 236b.

The first well region 236a and the second well region 236b may be collectively referred to as the well region 236.

As shown in FIG. 12, in the upper portion of the semiconductor layer 232, the doping region 238 may be formed. In the example embodiment, the doping region 238 may be positioned between the first well region 236a and the second well region 236b. The doping region 238 may be positioned appropriately at the center between the first well region 236a and the second well region 236b. In the example embodiment, the first well region 236a and the second well region 236b may have a symmetrical structure with respect to a line connecting the doping region 238 and the substrate 210 in the third direction DR3.

The doping region 238 may be formed by an ion implantation process. First, a fourth photoresist pattern P14 may be formed on the upper surfaces of the first portions 236a_1 and 236b_1 of the first well region 236a and the second well region 236b and the upper surface of the semiconductor layer 232 between the first portions 236a_1 and 236b_1 using a photolithography process, thereby defining a region where the doping region 238 will be formed. For example, a region corresponding to an opening of the fourth photoresist pattern P14 may be defined as a region where the doping region 238 will be formed. Thereafter, ions may be implanted into the corresponding region. The doping region 238 may have a predetermined depth. In this case, the depth of the doping region 238 may be determined by the number of ions which are implanted and/or the speed at which the ions are accelerated.

In the example embodiment, the depth of the doping region 238 may be smaller than the depth of the first portion 236a_1 of the first well region 236a and the first portion 236b_1 of the second well region 236b. The upper surfaces of the second portion 236a_2 of the first well region 236a and the second portion 236b_2 of the second well region 236b may be spaced apart from the lower surface of the doping region 238 in the third direction DR3.

The doping region 238 may contain SiC. For example, the doping region 238 may contain 4H SiC. The doping region 238 and the semiconductor layer 232 may have the same first conductivity type. The doping region 238 may be doped with an n-type impurity. The doping region 238 may be doped with an n-type impurity at a high concentration (e.g. a higher concentration than one or more of the semiconductor layer 232, the first well region 236a and the second well region 236b). The doping concentration of the doping region 238 may be equal to or higher than about 1×10¹⁸ cm⁻³ and equal to or lower than about 5×10²⁰ cm⁻³. The material, doping type, doping concentration, and the like of the doping region 238 are not limited thereto, and may be variously changed.

Hereinafter, different processes of manufacturing a semiconductor device according to an example embodiment will be described with reference to FIGS. 13 to 16.

As shown in FIG. 13, a semiconductor layer 232 may be formed on the substrate 210, and a doping layer 234 may be formed in the upper portion of the semiconductor layer 232. The process of FIG. 13 may correspond to the process of FIG. 9. In respect to each of the substrate 210, the semiconductor layer 232, and the doping layer 234, the description made with reference to FIG. 9 may be equally applied. Hereinafter, a description that is redundant to the description of FIG. 9 will be made briefly or will not be made.

On the upper surface of the substrate 210, the semiconductor layer 232 may be formed using an epitaxial growth method. In this case, the thickness of the semiconductor layer 232 may be larger than the thickness of the semiconductor layer 232 of FIG. 9.

The substrate 210 and the semiconductor layer 232 may contain SiC. The substrate 210 and the semiconductor layer 232 may have the first conductivity type. The substrate 210 and the semiconductor layer 232 may be doped with an n-type impurity. The substrate 210 may be doped with an n-type impurity at a high concentration, and the semiconductor layer 232 may be doped with an n-type impurity at a low concentration.

Subsequently, ions may be implanted into the upper portion of the semiconductor layer 232 to form the doping layer 234. First, a first photoresist pattern P21 may be formed on the upper surface of the semiconductor layer 232 using a photolithography process, thereby defining a region where the doping layer 234 will be formed. For example, a region corresponding to an opening of the first photoresist pattern P21 may be defined as a region where the doping layer 234 will be formed. Thereafter, ions may be implanted into the corresponding region, thereby forming the doping layer 234. The doping layer 234 may have a predetermined depth. In this case, the depth of the doping layer 234 may be larger than the depth of the doping layer 234 of FIG. 9.

The doping layer 234 may contain SiC. The doping layer 234 and the semiconductor layer 232 may have the same first conductivity type. The doping layer 234 may be doped with an n-type impurity. The doping layer 234 may be doped at a concentration higher than that of the semiconductor layer 232. For example, the doping concentration of the semiconductor layer 232 may be equal to or higher than about 1×10¹⁵ cm⁻³ and equal to or lower than about 1×10¹⁷ cm⁻³, and the doping concentration of the doping layer 234 may be equal to or higher than about 1×10¹⁷ cm⁻³ and equal to or lower than about 1×10¹⁹ cm⁻³.

In the example embodiment, the doping layer 234 may include the first doping layer 234a and the second doping layer 234b that are spaced apart from each other in the first direction DR1.

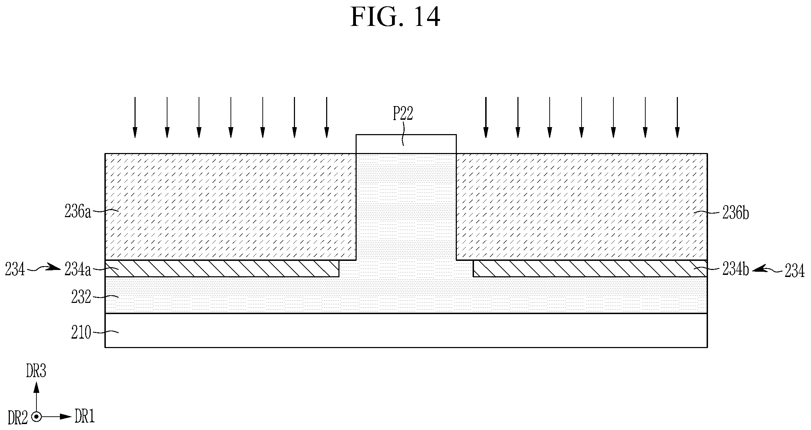

As shown in FIG. 14, in the upper portion of the doping layer 234, the first well region 236a and the second well region 236b may be formed. In the example embodiment, the first well region 236a may be formed in the upper portion of the first doping layer 234a, and the second well region 236b may be formed in the upper portion of the second doping layer 234b. The first well region 236a and the second well region 236b may be spaced apart from each other in the first direction DR1. The separation distance between the first well region 236a and the second well region 236b in the first direction DR1 may be equal to or smaller than the separation distance between the first doping layer 234a and the second doping layer 234b in the first direction DR1.

The first well region 236a and the second well region 236b may be formed by an ion implantation process. First, a second photoresist pattern P22 may be formed on the upper surface of the semiconductor layer 232 using a photolithography process, thereby defining regions where the first well region 236a and the second well region 236b will be formed. For example, regions corresponding to openings of the second photoresist pattern P22 may be defined as regions where the second portion 236a_2 of the first well region 236a and the second portion 236b_2 of the second well region 236b will be formed. Thereafter, ions may be implanted into the corresponding regions. The first well region 236a and the second well region 236b may have a predetermined depth.

In the example embodiment, the depth of the first well region 236a and the second well region 236b may be smaller than the depth of the first doping layer 234a and the second doping layer 234b of FIG. 13. At least a portion of the lower surface of the first well region 236a may be covered by the first doping layer 234a, and at least a portion of the lower surface of the second well region 236b may be covered by the second doping layer 234b.

In the example embodiment, the first well region 236a and the second well region 236b may contain SiC. The conductivity type of the first well region 236a and the second well region 236b may be the second conductivity type different from the conductivity type of the semiconductor layer 232. The first well region 236a and the second well region 236b may be doped with a p-type impurity. For example, the doping concentration of the first well region 236a and the second well region 236b may be equal to or higher than about 1×10¹⁷ cm⁻³ and equal to or lower than about 1×10¹⁹ cm⁻³.

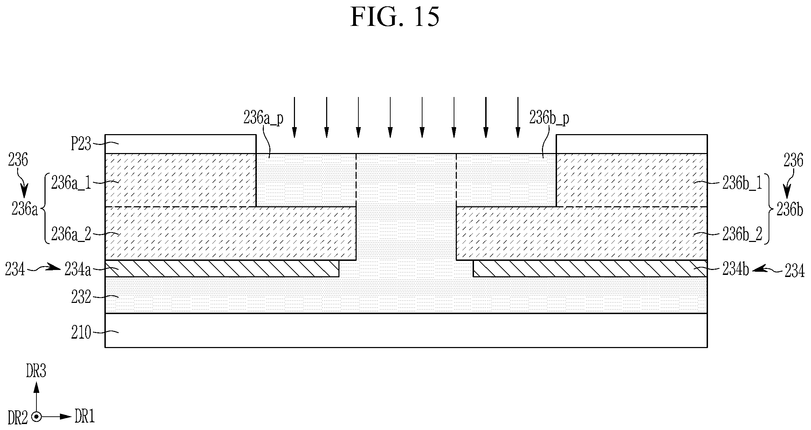

As shown in FIG. 15, the conductivity types of partial regions 236a_p and 236b_p of the first well region 236a and the second well region 236b may be changed. The partial regions 236a_p and 236b_p of the first well region 236a and the second well region 236b may be upper edge regions of the first well region 236a and the second well region 236b facing each other in the first direction DR1.

The conductivity type of the partial regions 236a_p and 236b_p of the first well region 236a and the second well region 236b may be changed by an ion implantation process. First, a third photoresist pattern P23 may be formed on the upper surface of the first well region 236a and the upper surface of the semiconductor layer 232 of the second well region 236b using a photolithography process, thereby defining regions to be doped into a conductivity type different from that of the first well region 236a and the second well region 236b. For example, a region corresponding to an opening of the third photoresist pattern P23 may be defined as a region to be doped into a conductivity type different from that of the first well region 236a and the second well region 236b. Thereafter, ions of a conductivity type different from that of the first well region 236a and the second well region 236b may be implanted into the corresponding region. The conductivity type of the partial regions 236a_p and 236b_p of the first well region 236a and the second well region 236b may be changed.

In the example embodiment, the first well region 236a and the second well region 236b may be the second conductivity type. An impurity of the first conductivity type may be implanted into the partial regions 236a_p and 236b_p of the first well region 236a and the second well region 236b, thereby changing the conductivity type of the partial regions 236a_p and 236b_p of the first well region 236a and the second well region 236b from the second conductivity type to the first conductivity type. For example, the first well region 236a and the second well region 236b may be doped with a p-type impurity. The partial regions 236a_p and 236b_p of the first well region 236a and the second well region 236b may be doped with an n-type impurity, thereby the conductivity type of the partial regions 236a_p and 236b_p changing from the p-type to the n-type.

In the example embodiment, the partial regions 236a_p and 236b_p of the first well region 236a and the second well region 236b may be doped so as to have substantially the same doping concentration as that of the semiconductor layer 232. The partial regions 236a_p and 236b_p of the first well region 236a and the second well region 236b whose conductivity type has been changed may have the same material and same doping type as the semiconductor layer 232, and have substantially the same doping concentration as that of the semiconductor layer. The partial regions 236a_p and 236b_p of the first well region 236a and the second well region 236b whose conductivity type has been changed may become portions of the semiconductor layer 232.

The depth of the partial regions 236a_p and 236b_p of the first well region 236a and the second well region 236b may be smaller than the depth of the first well region 236a and the second well region 236b of FIG. 14. Since the conductivity type of the partial regions 236a_p and 236b_p of the first well region 236a and the second well region 236b is changed, each of the first well region 236a and the second well region 236b may be distinguished into the first portion 236a_1 or 236b_1 and the second portion 236a_2 or 236b_2 with reference to the depth of the partial regions 236a_p and 236b_p of the first well region 236a and the second well region 236b.

Each of the first well region 236a and the second well region 236b may include a first portion 236a_1 or 236b_1 that is positioned at a depth shallower than the depth of the partial regions 236a_p and 236b_p of the first well region 236a and the second well region 236b, and a second portion 236a_2 or 236b_2 that is positioned at a depth deeper than the depth of the partial regions 236a_p and 236b_p of the first well region 236a and the second well region 236b. The second portion 236a_2 or 236b_2 may be closer to the upper surface of the substrate 210 than the first portion 236a_1 or 236b_1.

In the example embodiment, the separation distance between the first portion 236a_1 of the first well region 236a and the first portion 236b_1 of the second well region 236b in the first direction DR1 may be larger than the separation distance between the second portion 236a_2 of the first well region 236a and the second portion 236b_2 of the second well region 236b in the first direction DR1.

As shown in FIG. 16, the doping region 238 may be formed in the upper portion of the semiconductor layer 232. The process of FIG. 16 may correspond to the process of FIG. 12. In respect to the doping region 238, the description made with reference to FIG. 12 may be equally applied. Hereinafter, a description that is redundant to the description of FIG. 12 will be made briefly or will not be made.

The doping region 238 may be formed by an ion implantation process. First, a fourth photoresist pattern P24 may be formed on the upper surfaces of the first portions 236a_1 and 236b_1 of the first well region 236a and the second well region 236b and the upper surface of the semiconductor layer 232 between the first portions 236a_1 and 236b_1 using a photolithography process, thereby defining a region where the doping region 238 will be formed. For example, a region corresponding to an opening of the fourth photoresist pattern P24 may be defined as a region where the doping region 238 will be formed. Thereafter, ions may be implanted into the corresponding region. The doping region 238 may have a predetermined depth.

In the example embodiment, the depth of the doping region 238 may be smaller than the depth of the first portion 236a_1 of the first well region 236a and the first portion 236b_1 of the second well region 236b. The upper surfaces of the second portion 236a_2 of the first well region 236a and the second portion 236b_2 of the second well region 236b may be spaced apart from the lower surface of the doping region 238 in the third direction DR3.

The doping region 238 may contain SiC. The doping region 238 and the semiconductor layer 232 may have the same first conductivity type. The doping region 238 may be doped with an n-type impurity. The doping region 238 may be doped with an n-type impurity at a high concentration. The doping concentration of the doping region 238 may be higher than that of the semiconductor layer 232. For example, the doping concentration of the doping region 238 may be equal to or higher than about 1×10¹⁸ cm⁻³ and equal to or lower than about 5×10²⁰ cm⁻³.

Hereinafter, processes which are performed after the processes of FIGS. 9 to 12 or the processes of FIGS. 13 to 16 in order to manufacture the semiconductor device according to the example embodiment will be described with reference to FIGS. 17 to 20.

As shown in FIG. 17, the fourth photoresist pattern P14 of FIG. 12 or the fourth photoresist pattern P24 of FIG. 16 may be removed. Accordingly, the process of forming the layers containing SiC may be completed.

The semiconductor layer 232 may be positioned on the substrate 210, and the first well region 236a and the second well region 236b may be positioned in the upper portion of the semiconductor layer 232. The first well region 236a and the second well region 236b may be spaced apart from each other in the first direction DR1. The doping region 238 may be positioned between the first well region 236a and the second well region 236b.

In the example embodiment, the first well region 236a and the second well region 236b may have a symmetrical structure with respect to a line connecting the doping region 238 and the substrate 210 in the third direction DR3. The side surfaces of the first well region 236a and the second well region 236b facing each other in the first direction DR1 may have a step shape. The side surfaces of the first well region 236a and the second well region 236b facing each other may have a step shape that declines as it approaches the doping region 238 along the first direction DR1.

In the example embodiment, each of the first well region 236a and the second well region 236b may include the first portion 236a_1 or 236b_1 and the second portion 236a_2 or 236b_2. The second portion 236a_2 or 236b_2 of each of the first well region 236a and the second well region 236b may be closer to the upper surface of the substrate 210 than the first portion 236a_1 or 236b_1 of each of the first well region 236a and the second well region 236b.

In the example embodiment, the distance between the first portion 236a_1 of the first well region 236a and the first portion 236b_1 of the second well region 236b in the first direction DR1 may be longer than the distance between the second portion 236a_2 of the first well region 236a and the second portion 236b_2 of the second well region 236b.

In the example embodiment, the semiconductor layer 232 which is positioned between the first well region 236a and the second well region 236b may include the first semiconductor layer 232_1 and the second semiconductor layer 232_2. The first semiconductor layer 232_1 may be positioned between the first portion 236a_1 of the first well region 236a and the first portion 236b_1 of the second well region 236b. The second semiconductor layer 232_2 may be positioned between the second portion 236a_2 of the first well region 236a and the second portion 236b_2 of the second well region 236b. The first semiconductor layer 232_1 may be a portion adjacent to the doping region 238. The second semiconductor layer 232_2 may be a portion extending from the first semiconductor layer 232_1 toward the upper surface of the substrate 210. The second semiconductor layer 232_2 may be spaced apart from the doping region 238 in the third direction DR3 by the first semiconductor layer 232_1. In the example embodiment, the width of the first semiconductor layer 232_1 in the first direction DR1 may be larger than the width of the second semiconductor layer 232_2 in the first direction DR1.

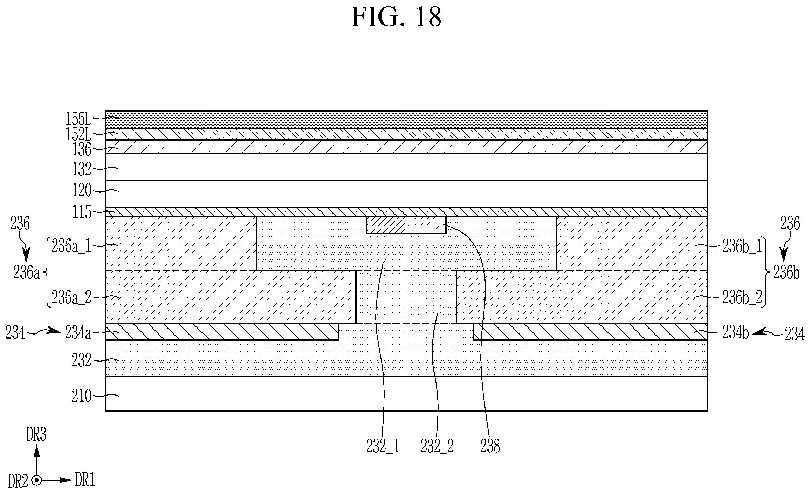

As shown in FIG. 18, on the semiconductor layer 232, the well region 236, and the doping region 238, the seed layer 115, the buffer layer 120, the channel layer 132, the barrier layer 136, a gate semiconductor material layer 152L, and a gate electrode material layer 155L may be sequentially formed.

The seed layer 115, the buffer layer 120, the channel layer 132, the barrier layer 136, and the gate semiconductor material layer 152L may be sequentially formed using an epitaxial growth method. On the semiconductor layer 232, the well region 236, and the doping region 238, the seed layer 115 may be first formed, and on the seed layer 115, the buffer layer 120 may be formed. The buffer layer 120 may include a superlattice layer and a high-resistivity layer. On the buffer layer 120, the channel layer 132 may be formed, and on the channel layer 132, the barrier layer 136 may be formed, and on the barrier layer 136, the gate semiconductor material layer 152L may be formed.

According to the example embodiment, the sum of the thicknesses of the seed layer 115, the buffer layer 120, the channel layer 132, the barrier layer 136, and the gate semiconductor material layer 152L may be equal to or smaller than 3 µm. In general, in a GaN HEMT, the sum of the thicknesses of layers formed by growing GaN should be equal to or larger than about 6 µm such that it has a high breakdown voltage characteristic capable of withstanding up to about 1200 V. Although the sum of the thicknesses of the seed layer 115, the buffer layer 120, the channel layer 132, the barrier layer 136, and the gate semiconductor layer 152 is equal to or smaller than about 3 µm, the semiconductor device 100 according to the example embodiment may have a high breakdown voltage characteristic due to the substrate 210 and the semiconductor layer 232 that are positioned between the channel layer 132 and the drain electrode 205 to be formed later, and the first well region 236a and the second well region 236b that are positioned inside the semiconductor layer 232. Further, as the thicknesses of the seed layer 115, the buffer layer 120, the channel layer 132, the barrier layer 136, and the gate semiconductor material layer 152L decrease, the time required to form them may decrease.

The seed layer 115, the buffer layer 120, the channel layer 132, the barrier layer 136, and the gate semiconductor material layer 152L may consist of semiconductor materials based on the same material. However, the material composition ratios of the individual layers may be different from one another in view of the roles of the individual layers, the performance required for the semiconductor device, and the like. The seed layer 115, the buffer layer 120, the channel layer 132, the barrier layer 136, and the gate semiconductor material layer 152L may contain a semiconductor material different from that of the semiconductor layer 232, the well region 236, and the doping region 238. The seed layer 115, the buffer layer 120, the channel layer 132, the barrier layer 136, and the gate semiconductor material layer 152L may contain III-V materials, for example, one or more materials selected from nitrides containing at least one material of Al, Ga, In, and B. The seed layer 115, the buffer layer 120, the channel layer 132, the barrier layer 136, and the gate semiconductor material layer 152L may be formed of AlₓIn_{y}Ga_{1-x-y}N (wherein 0≤x≤1, 0≤y≤1, and x+y≤1). For example, the seed layer 115, the buffer layer 120, the channel layer 132, the barrier layer 136, and the gate semiconductor material layer 152L may contain at least one of AlN, GaN, InN, InGaN, AlGaN, AlInN, and AlInGaN. The barrier layer 136 may contain a material having an energy band gap different from that of the channel layer 132. The barrier layer 136 may have an energy band gap higher than that of the channel layer 132. The gate semiconductor material layer 152L may contain a material having an energy band gap different from that of the barrier layer 136.

As an example, the seed layer 115 may contain AlN, the buffer layer 120 may contain GaN, the channel layer 132 may contain GaN, and the barrier layer 136 may contain AlGaN. The channel layer 132 and the barrier layer 136 may or may not be doped with an impurity. The gate semiconductor material layer 152L may contain GaN, and be doped with an impurity. The gate semiconductor material layer 152L may be doped with a p-type impurity, for example, magnesium (Mg).

Since the lattice structure of SiC and the lattice structure of GaN are different, it may not be easy to grow the channel layer 132, which consists of GaN, directly on the semiconductor layer 232, the well region 236, and the doping region 238 which consist of SiC. In the method of manufacturing the semiconductor device according to the example embodiment, the lattice structure of the channel layer 132 may be stably formed by first forming the seed layer 115, the buffer layer 120, and the like on the semiconductor layer 232, the well region 236, and the doping region 238 and then forming the channel layer 132.

Subsequently, the gate electrode material layer 155L may be formed on the gate semiconductor material layer 152L. The gate semiconductor material layer 152L may be positioned between the barrier layer 136 and the gate electrode material layer 155L.

The gate electrode material layer 155L may be formed using a deposition process. For example, the gate electrode material layer 155L may be formed using at least one of E-beam evaporation, sputtering, physical vapor deposition (PVD), thermal chemical vapor deposition (thermal CVD), low-pressure chemical vapor deposition (LP-CVD), plasma-enhanced chemical vapor deposition (PE-CVD), and atomic layer deposition (ALD) techniques, but is not limited thereto.

The gate electrode material layer 155L may contain a conductive material. For example, the gate electrode material layer 155L may contain a metal, a metal alloy, a conductive metal nitride, a metal silicide, a doped semiconductor material, a conductive metal oxide, or a conductive metal oxynitride. For example, the gate electrode material layer 155L may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The gate electrode material layer 155L may consist of a single layer or multiple layers.

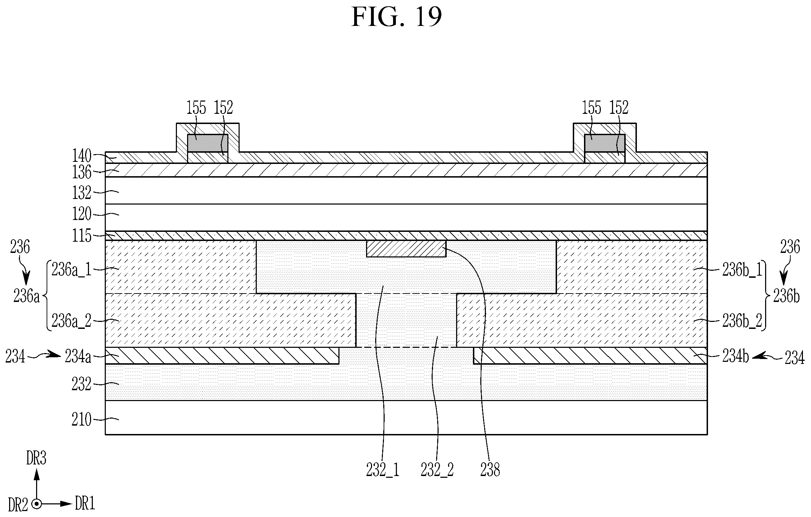

As shown in FIG. 19, the gate electrode 155 and the gate semiconductor layer 152 may be formed, and the first protective layer 140 may be formed on the barrier layer 136, the gate semiconductor layer 152, and the gate electrode 155.

First, the gate electrode 155 may be formed by patterning the gate electrode material layer 155L of FIG. 18. In this case, the gate electrode material layer 155L may be patterned using a wet etching process or a dry etching process.

Subsequently, the gate semiconductor layer 152 may be formed by patterning the gate semiconductor material layer 152L of FIG. 18. In this case, the gate semiconductor material layer 152L may be patterned using a dry etching process. The gate semiconductor layer 152 is positioned between the barrier layer 136 and the gate electrode 155. The gate electrode 155 may be brought into Schottky contact or ohmic contact with the gate semiconductor layer 152.

The gate semiconductor material layer 152L of FIG. 18 may be patterned using the hard mask or photoresist pattern remaining on the gate electrode 155. Accordingly, the gate semiconductor layer 152 may have a pattern similar to the gate electrode 155. In other words, the gate semiconductor layer 152 and the gate electrode 155 may have substantially the same planar shape. On a cross section along the first direction DR1 and the third direction DR3, the width of the gate semiconductor layer 152 may be substantially the same as the maximum width of the gate electrode 155.

Subsequently, on the barrier layer 136, the gate semiconductor layer 152, and the gate electrode 155, the first protective layer 140 may be formed. The first protective layer 140 may be formed using a deposition process. The first protective layer 140 may contain an insulating material. For example, the first protective layer 140 may contain a material such as SiO₂, SiN, SiON, and Al₂O₃. In the drawings, the first protective layer 140 is shown as a single layer; however, in some cases, the first protective layer may consist of multiple layers. In this case, the first protective layer 140 may be formed by sequentially depositing different materials. Alternatively, a first protective layer 140 that consists of multiple layers having different characteristics may be formed by depositing the same material under different deposition conditions. In an embodiment, the first protective layer 140 may include an insulating material, and portions of the first protective layer 140 adjacent to the barrier layer 136 may consist of an insulating material having higher film quality such as a density than the other portions. This configuration of the first protective layer 140 is for preventing electrons forming a channel (i.e., an electrical conduction path) from being trapped inside the channel layer 132 positioned below the barrier layer 136. The portions of the first protective layer 140 in contact with the barrier layer 136 may consist of SiO₂.

The upper surface of the barrier layer 136 may be covered by the first protective layer 140. The side surface of the gate semiconductor layer 152 may be covered by the first protective layer 140. The upper surface and side surface of the gate electrode 155 may be covered by the first protective layer 140.

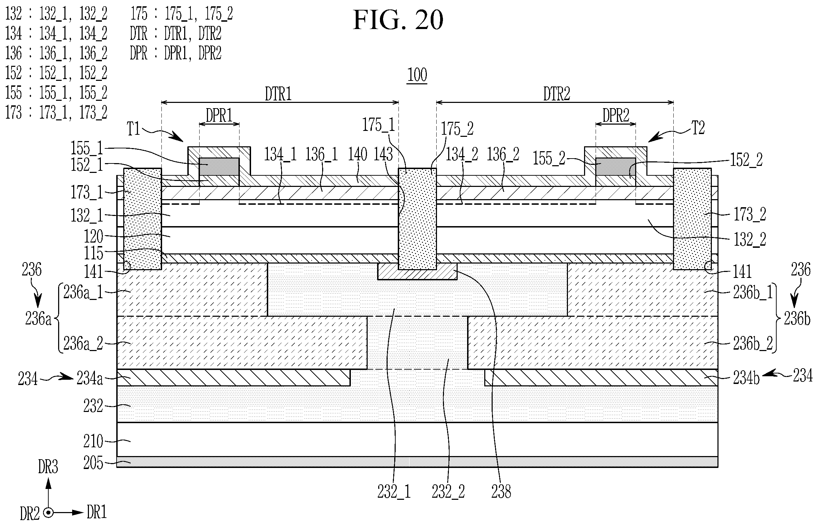

As shown in FIG. 20, the first protective layer 140, the barrier layer 136, the channel layer 132, the buffer layer 120, the seed layer 115, the well region 236, and the doping region 238 of FIG. 19 may be patterned to form the source electrode 173 and the connection electrode 175.

First, by patterning the first protective layer 140, the barrier layer 136, the channel layer 132, the buffer layer 120, the seed layer 115, the well region 236, and the doping region 238 of FIG. 19, a first trench 141 and a second trench 143 may be formed. A first trench 141 may be formed on either side of the second trench 143 (e.g. above each of the first well region 236a and the second well region 236b).

For example, a photoresist pattern may be formed on the first protective layer 140, and etching may be sequentially performed on the first protective layer 140, the barrier layer 136, the channel layer 132, the buffer layer 120, and the seed layer 115, using the photoresist pattern as a mask, and subsequently, etching may be performed on the well region 236 and the doping region 238. In this case, by the first trench 141 and the second trench 143, the first protective layer 140, the barrier layer 136, the channel layer 132, the buffer layer 120, and the seed layer 115 may be penetrated, and the upper surfaces of the well region 236 and the doping region 238 may be recessed. The well region 236 and the doping region 238 may not be penetrated by the first trench 141 or the second trench 143. In other words, the depths to which the upper surfaces of the well region 236 and the doping region 238 are recessed may be smaller than the total thicknesses of the well region 236 and the doping region 238. In this case, the depths to which the upper surfaces of the well region 236 and the doping region 238 are recessed may be significantly smaller than the total thicknesses of the well region 236 and the doping region 238. However, the present disclosure is not limited thereto, and in some cases, the upper surfaces of the well region 236 and the doping region 238 may not be recessed. By the first trench 141 and the second trench 143, the side surfaces of the first protective layer 140, the barrier layer 136, the channel layer 132, the buffer layer 120, and the seed layer 115 may be exposed to the outside, and the upper surfaces and side surfaces of the well region 236 and the doping region 238 may be exposed. The well region 236 and the doping region 238 may constitute the bottom surfaces and side walls of the first trench 141 and the second trench 143, and the first protective layer 140, the barrier layer 136, the channel layer 132, the buffer layer 120, and the seed layer 115 may constitute the side walls of the first trench 141 and the second trench 143.

The first trench 141 and the second trench 143 may be spaced apart from each other. The first trench 141 and the second trench 143 may be positioned on opposite sides of the gate electrode 155. The first trench 141 may be positioned on one side of the gate electrode 155, and may be spaced apart from the gate electrode 155. The second trench 143 may be positioned on the other side of the gate electrode 155 and may be spaced apart from the gate electrode 155. The separation distance of the first trench 141 from the gate electrode 155 may be smaller than the separation distance of the second trench 143 from the gate electrode 155. Although the first trench 141 and the second trench 143 are shown in shapes similar in the width, depth, and the like in the drawing, the present disclosure is not limited thereto. The shapes of the first trench 141 and the second trench 143 may be variously changed.

Subsequently, a conductive material may be deposited on the first protective layer 140 in which the first trench 141 and the second trench 143 have been formed, and the conductive material may be patterned, thereby forming the source electrode 173 and the connection electrode 175.

The source electrode 173 and the connection electrode 175 may contain a conductive material. For example, the source electrode 173 and the connection electrode 175 may contain a metal, a metal alloy, a conductive metal nitride, a metal silicide, a doped semiconductor material, a conductive metal oxide, or a conductive metal oxynitride. The source electrode 173 and the connection electrode 175 may consist of a single layer or multiple layers. For example, the source electrode 173 and the connection electrode 175 may be formed by stacking a plurality of conductive layers containing materials different from each other and then patterning them. In this case, the plurality of conductive layers may be etched simultaneously or sequentially using one mask pattern.

The source electrode 173 may be formed so as to fill the inside of the first trench 141. Inside the first trench, the source electrode 173 may be in contact with the first protective layer 140, the barrier layer 136, the channel layer 132, the buffer layer 120, the seed layer 115, and the well region 236. The source electrode 173 may be in contact with the side surfaces of the first protective layer 140, the barrier layer 136, the channel layer 132, the buffer layer 120, the seed layer 115, and the well region 236. The source electrode 173 may be in contact with the upper surface of the well region 236. The source electrode 173 may be electrically connected to the well region 236 through the first trench 141. At least a portion of the upper surface of the source electrode 173 may protrude from the upper surface of the first protective layer 140.

The connection electrode 175 may be formed so as to fill the inside of the second trench 143. Inside the second trench 143, the connection electrode 175 may be in contact with the first protective layer 140, the barrier layer 136, the channel layer 132, the buffer layer 120, the seed layer 115, and the doping region 238. The connection electrode 175 may be in contact with the side surfaces of the first protective layer 140, the barrier layer 136, the channel layer 132, the buffer layer 120, the seed layer 115, and the doping region 238. The connection electrode 175 may be in contact with the upper surface of the doping region 238. The connection electrode 175 may be electrically connected to the doping region 238 through the second trench 143. At least a portion of the upper surface of the connection electrode 175 may protrude from the upper surface of the first protective layer 140.

The source electrode 173 and the connection electrode 175 may be in ohmic contact with the channel layer 132. The regions in the channel layer 132 which are in contact with the source electrode 173 and the connection electrode 175 may be doped at a relatively higher concentration, as compared to the other region. For example, the channel layer 132 may be doped by an ion implantation process or an annealing process. However, the present disclosure is not limited thereto, and the process of doping the channel layer 132 may consist of various different processes. The process of doping the channel layer 132 may be performed before the source electrode 173 and the connection electrode 175 are formed. In some cases, the channel layer 132 may not be doped.

At the portion inside the channel layer 132 adjacent to the barrier layer 136, the 2-dimensional electron gas 134 may be formed. The 2-dimensional electron gas 134 may be positioned at the interface between the channel layer 132 and the barrier layer 136. The 2-dimensional electron gas 134 may be positioned in the drift region DTR between the source electrode 173 and the connection electrode 175. By the gate semiconductor layer 152 having an energy band gap different from that of the barrier layer 136, a depletion region DPR may be formed inside the channel layer 132.

According to the above-described process, the pair of high electron mobility transistors T1 and T2 may be formed. The pair of high electron mobility transistors T1 and T2 may include a first transistor T1 and a second transistor T2. The first transistor T1 may include a first channel layer 132_1 that is positioned on the semiconductor layer 232, a first barrier layer 136_1 that is positioned on the first channel layer 132_1, a first gate electrode 155_1 that is positioned on the first barrier layer 136_1, and a first source electrode 173_1 and a first connection electrode 175_1 that are positioned on opposite sides of the first gate electrode 155_1 and are spaced apart from each other in the first direction DR1. The second transistor T2 may include a second channel layer 132_2 that is positioned on the semiconductor layer 232, a second barrier layer 136_2 that is positioned on the second channel layer 132_2, a second gate electrode 155_2 that is positioned on the second barrier layer 136_2, and a second source electrode 173_2 and a second connection electrode 175_2 that are positioned on opposite sides of the second gate electrode 155_2 and are spaced apart from each other in the first direction DR1.

According to the example embodiment, the first connection electrode 175_1 and the second connection electrode 175_2 of the second transistor T2 may be integrally formed. In other words, the first transistor T1 and the second transistor T2 may include a single connection electrode 175, and this connection electrode 175 may be positioned between the first source electrode 173_1 and the second source electrode 173_2.

The pair of high electron mobility transistors T1 and T2 according to the example embodiment may have a normally-off characteristic. In the gate-off state, the 2-dimensional electron gas 134 may be positioned inside the drift region DTR except for the depletion region DPR of the channel layer 132. In the gate-on state, the flow of the 2-dimensional electron gas 134 continues inside the depletion region DPR, and thus the 2-dimensional electron gas 134 may be positioned throughout the inside of the drift region DTR.

Subsequently, on the second surface of the substrate 210, i.e., the lower surface, a conductive material may be deposited, and then the conductive material may be patterned, thereby forming the drain electrode 205. The drain electrode 205 may be in contact with the substrate 210.

According to the manufacturing method of FIGS. 9 to 12 and FIGS. 17 to 20 or the manufacturing method of FIGS. 13 to 20, the semiconductor device 100 including the substrate 210, the drain electrode 205 below the substrate 210, the semiconductor layer 232 on the substrate 210, and the pair of high electron mobility transistors T1 and T2 on the semiconductor layer 232 may be formed. Inside the semiconductor layer 232, the first well region 236a and the second well region 236b of a conductivity type different from that of the semiconductor layer 232 may be positioned, and between first well region 236a and the second well region 236b, the doping region 238 which is the same conductivity type as that of the semiconductor layer 232 and has a doping concentration higher than that of the semiconductor layer 232 may be positioned between the first well region 236a and the second well region 236b. The substrate 210, the semiconductor layer 232, the first well region 236a, the second well region 236b, and the doping region 238 may contain the first semiconductor material, and the channel layer 132 of the pair of high electron mobility transistors T1 and T2 may contain the second semiconductor material having electron mobility higher than that of the first semiconductor material. The first semiconductor material may be SiC, and the second semiconductor material may be GaN. The source electrode 173 of the pair of high electron mobility transistors T1 and T2 may be connected to each of the first well region 236a and the second well region 236b. The connection electrode 175 of the pair of high electron mobility transistors T1 and T2 may be connected to the doping region 238.

In the semiconductor device 100 according to the example embodiment, the pair of high electron mobility transistors T1 and T2 may serve as a switch, and the well region 236 may reduce leakage current and improve the breakdown voltage of the semiconductor device 100. Accordingly, the semiconductor device 100 having an improved switching speed while withstanding high voltage can be provided.

Embodiments are set out in the following Clauses:
Clause 1. A semiconductor device comprising:
   a substrate;
   a semiconductor layer positioned on a first surface of the substrate, wherein a conductivity type of the semiconductor layer is a first conductivity type;
   a drain electrode that is positioned on a second surface of the substrate which is opposite to the first surface;
   a first well region and a second well region positioned in the semiconductor layer and spaced apart from each other in a first direction parallel to an upper surface of the substrate, wherein a conductivity type of each of the first well region and the second well region is a second conductivity type different from the first conductivity type;
   a doping region positioned between the first well region and the second well region, wherein a conductivity type of the doping region is the first conductivity type; and
   a pair of high electron mobility transistors that are positioned on the semiconductor layer,
   wherein each of the pair of high electron mobility transistors includes:
      a channel layer that is positioned on the semiconductor layer;
      a barrier layer that is positioned on the channel layer;
      a gate electrode that is positioned on the barrier layer; and
      a source electrode and a connection electrode that are positioned on opposite sides of the gate electrode and are spaced apart in the first direction,
      wherein the channel layer of each of the pair of high electron mobility transistors contains a material having electron mobility higher than electron mobility of the semiconductor layer,
      wherein the source electrode of each of the pair of high electron mobility transistors contacts a corresponding well region of the first well region and the second well region,
      wherein the connection electrode of each of the pair of high electron mobility transistors contacts the doping region,
      wherein each of the first well region and the second well region includes a first portion adjacent to the source electrode, and a second portion adjacent to the first surface, and
      wherein, when viewed in a plan view, a maximum distance, in the first direction, between the first portion of the first well region and the first portion of the second well region is longer than a maximum distance, in the first direction, between the second portion of the first well region and the second portion of the second well region.
Clause 2. The semiconductor device of Clause 1,
   wherein, when viewed in a plan view, a maximum distance in the first direction between a side surface of the first portion that is positioned between the gate electrode and the connection electrode and a side surface of the connection electrode is shorter than a maximum distance in the first direction between a side surface of the gate electrode and the side surface of the connection electrode.
Clause 3. The semiconductor device of Clause 2,
   wherein, when viewed in a plan view, a maximum distance in the first direction between a side surface of the second portion that is positioned between the gate electrode and the connection electrode and the side surface of the connection electrode is shorter than a maximum distance in the first direction between the side surface of the first portion that is positioned between the gate electrode and the connection electrode and the side surface of the connection electrode.
Clause 4. The semiconductor device of Clause 3,
   wherein the first well region and the second well region have a symmetrical structure with respect to a line connecting the substrate and the doping region in a direction perpendicular to the first surface.
Clause 5. A semiconductor device comprising:
   a substrate;
   a semiconductor layer positioned on a first surface of the substrate, wherein a conductivity type of the semiconductor layer is a first conductivity type;
   a drain electrode that is positioned on a second surface of the substrate which is opposite to the first surface;
   a first well region and a second well region positioned in the semiconductor layer and spaced apart from each other in a first direction parallel to an upper surface of the substrate, wherein a conductivity type of each of the first well region and the second well region is a second conductivity type different from the first conductivity type;
   a doping region positioned between the first well region and the second well region, wherein a conductivity type of the doping region is the first conductivity type; and
   a pair of high electron mobility transistors that are positioned on the semiconductor layer, wherein each of the pair of high electron mobility transistors includes:
      a channel layer that is positioned on the semiconductor layer;
      a barrier layer that is positioned on the channel layer;
      a gate electrode that is positioned on the barrier layer; and
      a source electrode and a connection electrode that are positioned on both sides of the gate electrode and are spaced apart in the first direction,
      wherein the connection electrode is electrically connected to the drain electrode,
      wherein the channel layer of each of the pair of high electron mobility transistors contains a material having electron mobility higher than electron mobility of the semiconductor layer,
      wherein the source electrode of each of the pair of high electron mobility transistors contacts each of the first well region and the second well region,
      wherein the connection electrode of each of the pair of high electron mobility transistors contacts the doping region,
      wherein the semiconductor layer that is positioned between the first well region and the second well region includes a first semiconductor layer adjacent to the doping region, and a second semiconductor layer extending from the first semiconductor layer toward the first surface, and
      wherein a width, in the first direction, of the first semiconductor layer is larger than a width, in the first direction, of the second semiconductor layer.

While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

## Claims

1. A semiconductor device comprising:
a substrate (210);
a semiconductor layer (232) positioned on a first surface of the substrate (210), wherein a conductivity type of the semiconductor layer (232) is a first conductivity type;
a drain electrode (205) that is positioned on a second surface of the substrate (210) which is opposite to the first surface;
a first well region (236a) and a second well region (236b) positioned in the semiconductor layer (232) and spaced apart from each other in a first direction parallel to an upper surface of the substrate (210), wherein a conductivity type of each of the first well region (236a) and the second well region (236b) is a second conductivity type different from the first conductivity type;
a doping region (238) positioned between the first well region (236a) and the second well region (236b), wherein a conductivity type of the doping region (238) is the first conductivity type; and
a pair of high electron mobility transistors (T1, T2) that are positioned on the semiconductor layer (232),
wherein each of the pair of high electron mobility transistors (T1, T2) includes:
a channel layer (132) that is positioned on the semiconductor layer (232);
a gate electrode (155) that is positioned on the channel layer (132); and
a source electrode (173) and a connection electrode (175) that are positioned on opposite sides of the gate electrode (155) and are spaced apart in the first direction,
wherein the source electrode (173) of each of the pair of high electron mobility transistors (T1, T2) contacts each of the first well region (236a) and the second well region (236b),
wherein the connection electrode (175) of each of the pair of high electron mobility transistors contacts the doping region (238),
wherein each of the first well region (236a) and the second well region (236b) includes a first portion adjacent to the source electrode (173), and a second portion adjacent to the first surface, and
wherein, when viewed in a plan view, a distance, in the first direction, between the first portion of the first well region (236a) and the first portion of the second well region (236b) is longer than a distance, in the first direction, between the second portion of the first well region (236a) and the second portion of the second well region (236b).

2. The semiconductor device of claim 1,
wherein, when viewed in a plan view, a side surface of the first portion that is positioned between the gate electrode (155) and the connection electrode (175) is closer to the connection electrode (175) than a side surface of the gate electrode in the first direction.

3. The semiconductor device of claim 1 or claim 2,
wherein, when viewed in a plan view, a side surface of the second portion that is positioned between the gate electrode (155) and the connection electrode (175) is closer to the connection electrode (175) than a side surface of the first portion that is positioned between the gate electrode (155) and the connection electrode (175) in the first direction.

4. The semiconductor device of any preceding claim,
wherein, when viewed in a plan view, a portion of the semiconductor layer (232) is positioned in a direction perpendicular to the first surface between an upper surface of the second portion and a lower surface of the channel layer (132).

5. The semiconductor device of any preceding claim, wherein:
each of the first well region (236a) and the second well region (236b) further includes a third portion that is positioned between the first portion and the second portion, and
when viewed in a plan view, a distance between the third portion of the first well region (236a) and the third portion of the second well region (236b) in the first direction is shorter than the distance between the first portion of the first well region (236a) and the first portion of the second well region (236b) in the first direction, and is longer than the distance between the second portion of the first well region (236a) and the second portion of the second well region (236b) in the first direction.

6. The semiconductor device of any preceding claim,
wherein, when viewed in a cross-sectional view, a distance, in the first direction, between the first portion of the first well region (236a) and the first portion of the second well region (236b) has a decreasing distance toward the first surface.

7. The semiconductor device of claim 6,
wherein a side surface of the first portion that is positioned between the gate electrode (155) and the connection electrode (175) includes a curved surface connecting an upper surface of the first portion to a side surface of the second portion that is positioned between the gate electrode (155) and the connection electrode (175).

8. The semiconductor device of claim 7,
wherein, when viewed in a cross-sectional view, an inclination of the side surface of the first portion has a decreasing inclination toward the first surface.

9. The semiconductor device of any preceding claim,
wherein the doping region (238) has an impurity concentration higher than an impurity concentration of the semiconductor layer (232).

10. The semiconductor device of any preceding claim, further comprising:
a doping layer (234) positioned between the semiconductor layer and a lower surface of each of the first well region (236a) and the second well region (236b),
wherein a conductivity type of the doping layer (234) is the first conductivity type.

11. The semiconductor device of claim 10, wherein:
the doping layer (234) includes a first doping layer (234a) that is positioned between the lower surface of the first well region (236a) and the semiconductor layer (232), and a second doping layer (234b) that is positioned between the lower surface of the second well region (236b) and the semiconductor layer (232), and
the first doping layer (234a) and the second doping layer (234b) are spaced apart from each other in the first direction.

12. The semiconductor device of any preceding claim,
wherein:
the semiconductor layer (232) contains a first semiconductor material, and
the channel layer (132) contains a second semiconductor material different from the first semiconductor material.

13. The semiconductor device of any preceding claim, further comprising:
a barrier layer (136) that is positioned on the channel layer (132),
wherein each of the pair of high electron mobility transistors (T1, T2) further includes a gate semiconductor layer (152) that is positioned between the barrier layer (136) and the gate electrode (155).

14. The semiconductor device of claim 13, further comprising: a seed layer (115) and a buffer layer (120) between the semiconductor layer (232) and the channel layer (132),
wherein a sum of a thickness of the seed layer (115), a thickness of a buffer layer (120), a thickness of the channel layer (132), a thickness of the barrier layer (136), and a thickness of the gate semiconductor layer (152) is less than or equal to 3 µm.

15. The semiconductor device of claim 13 or claim 14,
wherein:
each of the pair of high electron mobility transistors (T1, T2) further includes:
a spacer layer (135) that is positioned between the barrier layer (136) and the channel layer (132); and
a gate barrier layer (151) that is positioned between the barrier layer (136) and the gate semiconductor layer (152).
